# EUROPEAN PATENT APPLICATION

(11) **EP 3 819 958 A1**
(43) Date of publication of application: **12.05.2021**
(21) Application number: 19830890.0
(22) Date of filing: 03.07.2019
(51) Int. Cl.: H01L 51/50, C08G 61/12, H05B 33/10

(54) **CHARGE-TRANSPORTING COMPOSITION**

(30) Priority: 04.07.2018 JP 2018127316; 14.09.2018 JP 2018172030
(71) Applicant: Nissan Chemical Corporation, Tokyo 103-6119 (JP)
(72) Inventor: HIGASHI Masayuki, Funabashi-shi, Chiba 274-0052 (JP)
(74) Representative: Mewburn Ellis LLP
(86) International application number: PCT/JP2019/026412
(87) International publication number: WO 2020/009138

(57) **Abstract**

Provided is a charge-transporting composition that contains: a charge-transporting substance comprising a polythiophene derivative of formula (1) or an amine adduct thereof; an organosilane compound selected from fluoroalkyl-group-containing silanes, etc.; metal oxide nanoparticles; and an organic solvent. 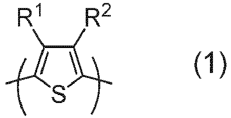 (R¹ and R² are, mutually independently, a hydrogen atom, a C1-40 alkoxy group, -O-[Z-O]ₚ-R^{e}, a sulfonic acid group, etc., or are -O-Y-O- formed by the bonding of R¹ and R²; Y is a C1-40 alkylene group that may contain an ether bond, or may be substituted with a sulfonic acid group; Z is a C1-40 alkylene group that may be substituted with a halogen atom; p is an integer of 1 or greater; and R^{e} is a hydrogen atom, a C1-40 alkyl group, etc.)).

## Description

### TECHNICAL FIELD

The present invention relates to a charge-transporting composition.

### BACKGROUND ART

Organic electroluminescence (EL) devices are expected to be put into practical use in fields such as displays and lighting. Accordingly, in recent years, various developments have been made for materials and device structures for the purpose of low voltage drive, high luminance, long lifetime, etc.

From the viewpoint of improving the performance of organic EL devices, a plurality of functional thin films are used. Among them, a hole injection layer and a hole transport layer achieve important functions, because they are responsible for the transfer and receipt of electric charge between the anode and the light emitting layer, and reduce the voltage drive and improve the luminance of organic EL devices.

The methods for forming the hole injection layer and the hole transport layer are roughly classified into a dry process represented by a vapor deposition method and a wet process represented by a spin coating method. Comparing these processes to each other, the wet process can efficiently produce a thin film having high flatness over a large area. Accordingly, the wet process is often used, especially in the field of displays.

At present, improvement is required of the performance of organic EL devices, and thus improvement is constantly required of wet process materials for a hole injection layer and a hole transport layer. In particular, there is an increasing demand for materials that provide charge-transporting thin films having excellent flatness, because they can contribute to improvement of the luminance characteristics and lifetime characteristics of organic EL devices.

### PRIOR ART DOCUMENTS

### PATENT DOCUMENTS

Patent Document 1: JP-A 2003-045667
Patent Document 2: JP-A 2007-169593
Patent Document 3: WO 2017/014946
Patent Document 4: WO 2008/129947
Patent Document 5: WO 2017/041701

### SUMMARY OF INVENTION

### TECHNICAL PROBLEM

The present invention has been made in view of the above circumstances, and has an object to provide a charge-transporting composition capable of forming a thin film, which can have high flatness and high charge transportability, and achieve excellent luminance characteristics when applied to an organic EL device.

### SOLUTION TO PROBLEM

As a result of diligent studies to achieve the above object, the present inventors have found that a charge-transporting composition including a predetermined charge-transporting substance containing a polythiophene derivative or an amine adduct thereof, a predetermined organosilane compound containing a fluorine atom, metal oxide nanoparticles, and a solvent can provide a thin film having high flatness and high charge transportability, as well as have found that excellent luminance characteristics can be exhibited when the thin film is applied to an organic EL device, leading to completion of this invention.

Note that it has been reported that incorporating glycidoxypropyltrimethoxysilane or a predetermined siloxane-based substance into a composition containing a conductive polymer such as polystyrene sulfonic acid or polyaniline can improve the luminance characteristics and lifetime of an organic EL device including a thin film obtained from the composition (see Patent Documents 1 and 2), but there is no report on a charge-transporting composition containing an organosilane compound used in the present invention.

That is, the present invention provides:
1. A charge-transporting composition, including: a charge-transporting substance containing a polythiophene derivative including a repeating unit represented by the formula (1) or an amine adduct thereof; at least one organosilane compound selected from fluoroalkyl group-containing silanes and fluoroaryl group-containing silanes; metal oxide nanoparticles; and a solvent: 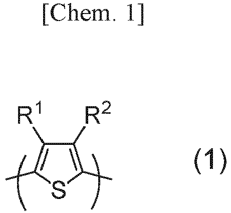 wherein R¹ and R² are each independently a hydrogen atom, a C1-40 alkyl group, a C1-40 fluoroalkyl group, a C1-40 alkoxy group, a C1-40 fluoroalkoxy group, a C6-20 aryloxy group, -O-[Z-O]ₚ-R^{e} or a sulfonic acid group, or are -O-Y-O- formed by the bonding of R¹ and R², wherein Y is a C1-40 alkylene group which may contain an ether bond or may be substituted with a sulfonic acid group, Z is a C1-40 alkylene group which may be substituted with a halogen atom, p is an integer of 1 or greater, R^{e} is a hydrogen atom, a C1-40 alkyl group, a C1-40 fluoroalkyl group or a C6-20 aryl group.
2. The charge-transporting composition of item 1, wherein the fluoroalkyl group-containing silanes and the fluoroaryl group-containing silanes have a fluoroalkyl group and a fluoroaryl group at the terminal of at least one molecule, respectively.
3. The charge-transporting composition of item 1 or 2, wherein the fluoroalkyl group and the fluoroaryl group are a perfluoroalkyl group and a perfluoroaryl group, respectively.
4. The charge-transporting composition of item 3, wherein the organosilane compound is at least one selected from the following formulas (A1) and (B1): 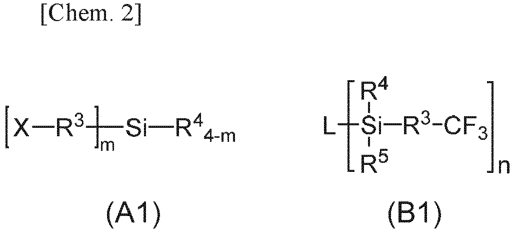 wherein R³ is a single bond, a C1-20 alkylene group, a C6-20 arylene group, an ester bond, an ether bond or a carbonyl bond, R⁴ and R⁵ are each independently a C1-20 alkyl group, a C1-20 alkoxy group or a C1-10 trialkylsilyl group, X is a C1-20 perfluoroalkyl group or a C6-20 perfluoroaryl group, L is O, S or N, m is 1 or 2, and n is 2 or 3.
5. The charge-transporting composition of any one of items 1 to 4, wherein the metal oxide nanoparticles are SiO₂.
6. The charge-transporting composition of any one of items 1 to 5, wherein R¹ is a sulfonic acid group and R² is a C1-40 alkoxy group or -O-[Z-O]ₚ-R^{e}, or R¹ and R² are -O-Y-O- formed by the bonding of R¹ and R².
7. The charge-transporting composition of any one of items 1 to 6, further including an electron-accepting dopant substance.
8. The charge-transporting composition of item 7, wherein the electron-accepting dopant substance is an aryl sulfonic acid compound.
9. A charge-transporting thin film obtained from the charge-transporting composition of any one of items 1 to 8.
10. An organic electroluminescence device having the charge-transporting thin film of item 9.
11. The organic electroluminescence device of item 9, wherein the charge-transporting thin film is a hole injection layer or a hole transport layer.
12. A method for producing a charge-transporting thin film, the method including applying the charge-transporting composition of any one of items 1 to 8 onto a substrate and evaporating a solvent.
13. A method for producing an organic electroluminescence device, the method including using the charge-transporting thin film of item 9.

### ADVANTAGEOUS EFFECTS OF INVENTION

By using the charge-transporting composition of the present invention, a charge-transporting thin film having good flatness can be obtained with good reproducibility by various wet processes.

By applying the charge-transporting thin film of the present invention having good flatness to a hole injection layer or a hole transport layer, preferably a hole injection layer of an organic EL device, it is possible to reduce the drive voltage of the device, improve the quantum efficiency, and extend the lifetime.

In addition, the charge-transporting composition of the present invention can fully cope with recent developments in the field of organic EL devices, because even when various wet processes that can form a thin film over a large area, such as a spin coating method and an inkjet method, are used, a thin film having excellent charge transportability can be produced with good reproducibility.

### BRIEF DESCRIPTION OF DRAWINGS

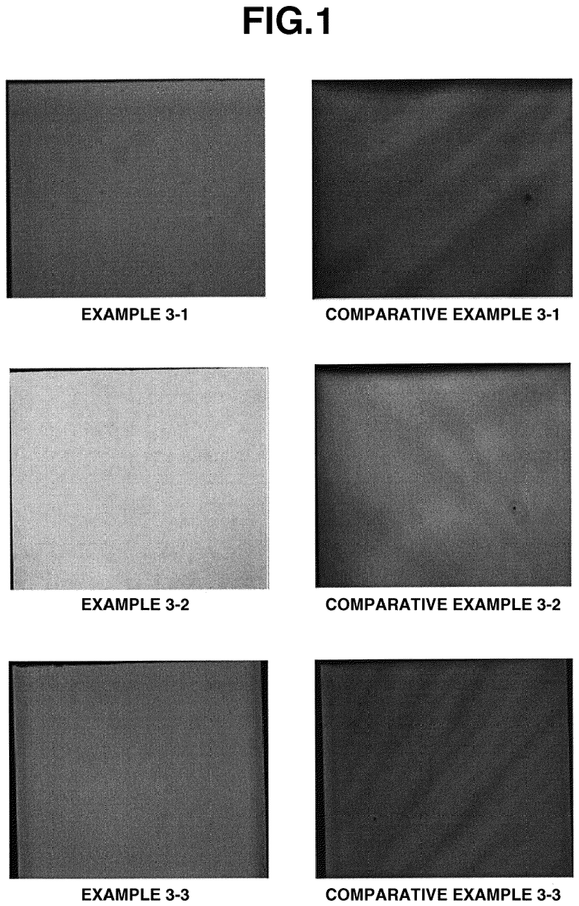

[FIG. 1] FIG. 1 is light emitting images of organic EL devices produced in Examples 3-1 to 3-3 and Comparative Examples 3-1 to 3-3.

### DESCRIPTION OF EMBODIMENTS

Hereinafter, the present invention is described in more detail. In the present invention, the "solid content" involved in the charge-transporting composition of the present invention means a component other than the solvent contained in the composition. In addition, charge transportability is synonymous with conductivity, and is also synonymous with hole transportability.

The charge-transporting composition of the present invention includes a charge-transporting substance containing a polythiophene derivative including a repeating unit represented by the formula (1) or an amine adduct thereof, at least one kind of organosilane compounds selected from fluoroalkyl group-containing silanes and fluoroaryl group-containing silanes, metal oxide nanoparticles, and an organic solvent.

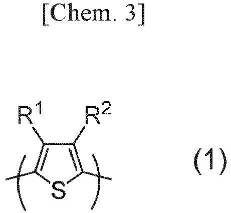

In the formula, R¹ and R² are each independently a hydrogen atom, a C1-40 alkyl group, a C1-40 fluoroalkyl group, a C1-40 alkoxy group, a C1-40 fluoroalkoxy group, a C6-20 aryloxy group, -O-[Z-O]ₚ-R^{e} or a sulfonic acid group, or are -O-Y-O- formed by the bonding of R¹ and R², wherein Y is a C1-40 alkylene group which may contain an ether bond or may be substituted with a sulfonic acid group, Z is a C1-40 alkylene group which may be substituted with a halogen atom, p is an integer of 1 or greater, R^{e} is a hydrogen atom, a C1-40 alkyl group, a C1-40 fluoroalkyl group or a C6-20 aryl group.

The C1-40 alkyl group may be linear, branched or cyclic. Specific examples of the C1-40 alkyl group include a methyl group, an ethyl group, an n-propyl group, an isopropyl group, an n-butyl group, an isobutyl group, an s-butyl group, a t-butyl group, an n-pentyl group, an n-hexyl group, an n-heptyl group, an n-octyl group, an n-nonyl group, an n-decyl group, an n-undecyl group, an n-dodecyl group, an n-tridecyl group, an n-tetradecyl group, an n-pentadecyl group, an n-hexadecyl group, a heptadecyl group, an n-octadecyl group, an n-nonadecil group, an n-eicosanyl group, a behenyl group, a triacontyl group and a tetracontyl group. Among them, a C1-18 alkyl group is preferable, and a C1-8 alkyl group is more preferable.

The C1-40 fluoroalkyl group may include a group which is the above-mentioned C1-40 alkyl group having at least one hydrogen atom substituted with a fluorine atom. Examples of the C1-40 fluoroalkyl group include, but are not particularly limited to, a fluoromethyl group, a difluoromethyl group, a perfluoromethyl group, a 1-fluoroethyl group, a 2-fluoroethyl group, a 1,2-difluoroethyl group, a 1,1-difluoroethyl group, a 2,2-difluoroethyl group, a 1,1,2-trifluoroethyl group, a 1,2,2-trifluoroethyl group, a 2,2,2-trifluoroethyl group, a 1,1,2,2-tetrafluoroethyl group, a 1,2,2,2-tetrafluoroethyl group, perfluoroethyl group, a 1-fluoropropyl group, a 2-fluoropropyl group, a 3-fluoropropyl group, a 1,1-difluoropropyl group, a 1,2-difluoropropyl group, a 1,3-difluoropropyl group, a 2,2-difluoropropyl group, a 2,3-difluoropropyl group, a 3,3-difluoropropyl group, a 1,1,2-trifluoropropyl group, a 1,1,3-trifluoropropyl group, a 1,2,3-trifluoropropyl group, a 1,3,3-trifluoropropyl group, a 2,2,3-trifluoropropyl group, a 2,3,3-trifluoropropyl group, a 3,3,3-trifluoropropyl group, a 1,1,2,2-tetrafluoropropyl group, a 1,1,2,3-tetrafluoropropyl group, a 1,2,2,3-tetrafluoropropyl group, a 1,3,3,3-tetrafluoropropyl group, a 2,2,3,3-tetrafluoropropyl group, a 2,3,3,3-tetrafluoropropyl group, a 1,1,2,2,3-pentafluoropropyl group, a 1,2,2,3,3-pentafluoropropyl group, a 1,1,3,3,3-pentafluoropropyl group, a 1,2,3,3,3-pentafluoropropyl group, a 2,2,3,3,3-pentafluoropropyl group, a perfluoropropyl group, a perfluorobutyl group, a perfluoropentyl group, a perfluorohexyl group, a perfluoroheptyl group and a perfluorooctyl group.

The alkyl group in the C1-40 alkoxy group may be linear, branched or cyclic. Examples of the C1-40 alkoxy group include, but are not limited to, a methoxy group, an ethoxy group, an n-propoxy group, an i-propoxy group, a c-propoxy group, an n-butoxy group, an i-butoxy group, an s-butoxy group, a t-butoxy group, an n-pentoxy group, an n-hexoxy group, an n-heptyloxy group, an n-octyloxy group, an n-nonyloxy group, an n-decyloxy group, an n-undecyloxy group, an n-dodecyloxy group, an n-tridecyloxy group, an n-tetradecyloxy group, an n-pentadecyloxy group, an n-hexadecyloxy group, an n-heptadecyloxy group, an n-octadecyloxy group, an n-nonadesyloxy group and an n-eicosanyloxy group.

The C1-40 fluoroalkoxy group is not particularly limited as long as it is an alkoxy group in which at least one hydrogen atom on the carbon atom is substituted with a fluorine atom. Examples of the C1-40 fluoroalkoxy group include a fluoromethoxy group, a difluoromethoxy group, a perfluoromethoxy group, a 1-fluoroethoxy group, a 2-fluoroethoxy group, a 1,2-difluoroethoxy group, a 1,1-difluoroethoxy group, a 2,2-difluoroethoxy group, a 1,1,2-trifluoroethoxy group, a 1,2,2-trifluoroethoxy group, a 2,2,2-trifluoroethoxy group, a 1,1,2,2-tetrafluoroethoxy group, a 1,2,2,2-tetrafluoroethoxy group, a perfluoroethoxy group, a 1-fluoropropoxy group, a 2-fluoropropoxy group, a 3-fluoropropoxy group, a 1,1-difluoropropoxy group, a 1,2-difluoropropoxy group, a 1,3-difluoropropoxy group, a 2,2-difluoropropoxy group, a 2,3-difluoropropoxy group, a 3,3-difluoropropoxy group, a 1,1,2-trifluoropropoxy group, a 1,1,3-trifluoropropoxy group, a 1,2,3-trifluoropropoxy group, a 1,3,3-trifluoropropoxy group, a 2,2,3-trifluoropropoxy group, a 2,3,3-trifluoropropoxy group, a 3,3,3-trifluoropropoxy group, a 1,1,2,2-tetrafluoropropoxy group, a 1,1,2,3-tetrafluoropropoxy group, a 1,2,2,3-tetrafluoropropoxy group, a 1,3,3,3-tetrafluoropropoxy group, a 2,2,3,3-tetrafluoropropoxy group, a 2,3,3,3-tetrafluoropropoxy group, a 1,1,2,2,3-pentafluoropropoxy group, a 1,2,2,3,3-pentafluoropropoxy group, a 1,1,3,3,3-pentafluoropropoxy group, a 1,2,3,3,3-pentafluoropropoxy group, a 2,2,3,3,3-pentafluoropropoxy group and a perfluoropropoxy group.

The C1-40 alkylene group may be linear, branched or cyclic. Examples of the C1-40 alkylene group include, but are not limited to, a methylene group, an ethylene group, a propylene group, a trimethylene group, a tetramethylene group, a pentylene group, a hexylene group, a heptylene group, an octylene group, a nonylene group, a decylene group, an undecylene group, a dodecylene group, a tridecylene group, a tetradecylene group, a pentadecylene group, a hexadecylene group, a heptadecylene group, an octadecylene group, a nonadesilene group and an eikosanylene group.

Examples of the C6-20 aryl group include a phenyl group, a tolyl group, a 1-naphthyl group, a 2-naphthyl group, a 1-anthryl group, a 2-anthryl group, a 9-anthryl group, a 1-phenanthryl group, a 2-phenanthryl group, a 3-phenanthryl group, a 4-phenanthryl group and a 9-phenanthryl group. Among them, a phenyl group, a tolyl group and a naphthyl group are preferable.

Examples of the C6-20 aryloxy group include, but are not limited to, a phenoxy group, an anthracenoxy group, a naphthoxy group, a phenanthrenoxy group and a fluorenoxy group.

The halogen atom includes a fluorine atom, a chlorine atom, a bromine atom and an iodine atom.

In the polythiophene derivative including the repeating unit represented by the formula (1), R¹ and R² are preferably each independently a hydrogen atom, a C1-40 fluoroalkyl group, a C1-40 alkoxy group, -O[C(R^{a}R^{b})-C(R^{c}R^{d})-O]ₚ-R^{e}, -OR^{f} or a sulfonic acid group, or are -O-Y-O- formed by the bonding of R¹ and R².

R^{a} to R^{d} each independently represent a hydrogen atom, a C1-40 alkyl group, a C1-40 fluoroalkyl group or a C6-20 aryl group, and specific examples of these groups are the same as those listed above.

Among them, R^{a} to R^{d} are preferably each independently a hydrogen atom, a C1-8 alkyl group, a C1-8 fluoroalkyl group or a phenyl group.

R^{e} is preferably a hydrogen atom, a C1-8 alkyl group, a C1-8 fluoroalkyl group or a phenyl group, more preferably a hydrogen atom, a methyl group, a propyl group or a butyl group.

In addition, p is preferably 1, 2 or 3.

In addition, R^{f} is preferably a hydrogen atom, a C1-40 alkyl group, a C1-40 fluoroalkyl group or a C6-20 aryl group, more preferably a hydrogen atom, a C1-8 alkyl group, a C1-8 fluoroalkyl group or a phenyl group, even more preferably -CH₂CF₃.

In the present invention, R¹ is preferably a hydrogen atom or a sulfonic acid group, more preferably a sulfonic acid group, and R² is preferably a C1-40 alkoxy group or -O-[Z-O]ₚ-R^{e}, more preferably -O[C(R^{a}R^{b})-C(R^{c}R^{d})-O]ₚ-R^{e} or -OR^{f}, even more preferably -O[C(R^{a}R^{b})-C(R^{c}R^{d})-O]ₚ-R^{e}, -O-CH₂CH₂-O-CH₂CH₂-O-CH₃, -O-CH₂CH₂-O-CH₂CH₂-OH or -O-CH₂CH₂-OH, or R¹ and R² are preferably -O-Y-O- formed by the bonding to each other.

For example, the polythiophene derivative according to a preferable embodiment of the present invention includes a repeating unit in which R¹ is a sulfonic acid group and R² is a group other than a sulfonic acid group, or includes a repeating unit that is -O-Y-O-formed by the bonding of R¹ and R².

That is, preferably, the polythiophene derivative includes a repeating unit in which R¹ is a sulfonic acid group and R² is a C1-40 alkoxy group or -O-[Z-O]ₚ-R^{e}, or includes a repeating unit that is -O-Y-O- formed by the bonding of R¹ and R².

More preferably, the polythiophene derivative includes a repeating unit in which R¹ is a sulfonic acid group and R² is -O[C(R^{a}R^{b})-C(R^{c}R^{d})-O]ₚ-R^{e} or -OR^{f}.

Even more preferably, the polythiophene derivative includes a repeating unit in which R¹ is a sulfonic acid group and R² is -O[C(R^{a}R^{b})-C(R^{c}R^{d})-O]ₚ-R^{e}, or includes a repeating unit that is -O-Y-O- formed by the bonding of R¹ and R².

More preferably, the polythiophene derivative includes a repeating unit in which R¹ is a sulfonic acid group and R² is -O-CH₂CH₂-O-CH₂CH₂-O-CH₃, -O-CH₂CH₂-O-CH₂CH₂-OH or -O-CH₂CH₂-OH, or includes a repeating unit that is a group represented by the following formulas (Y1) and (Y2) formed by the bonding of R¹ and R².

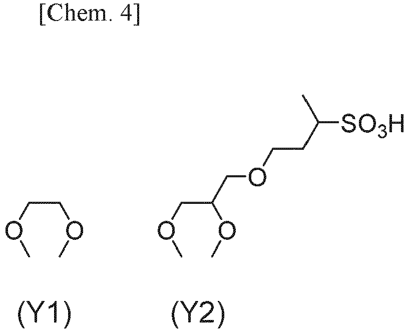

Preferable specific examples of the polythiophene derivative may include a polythiophene including any of the repeating units represented by the following formulas (1-1) to (1-5).

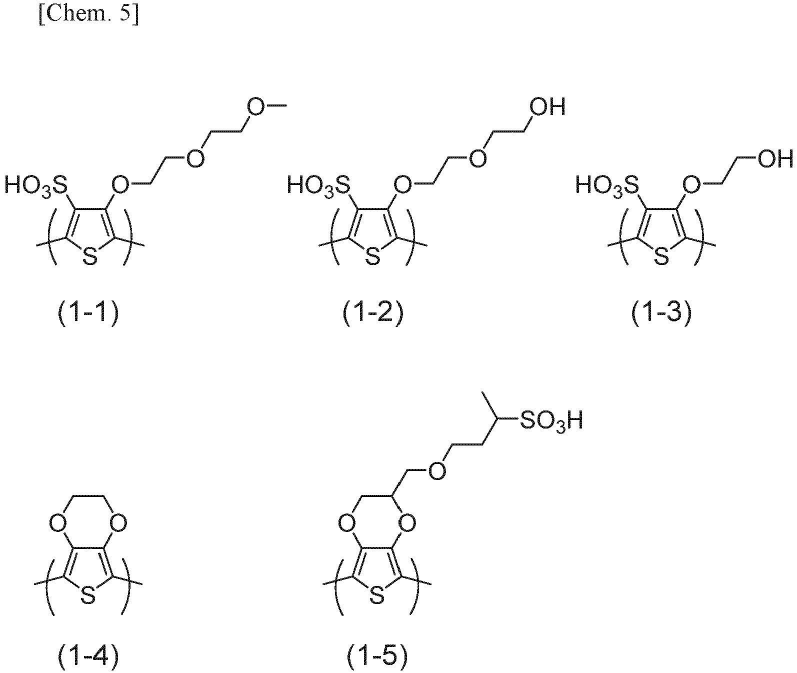

In addition, the polythiophene derivative does not necessarily have sulfonic acid groups in all the repeating units. Therefore, it is not necessary that all the repeating units have the same structure, but repeating units having different structures may be included. Examples of the suitable structure may include, but are not limited to, a polythiophene derivative having a structure represented by the following formula (1a). In the following formula, the units may be bonded to each other at random or as a block polymer.

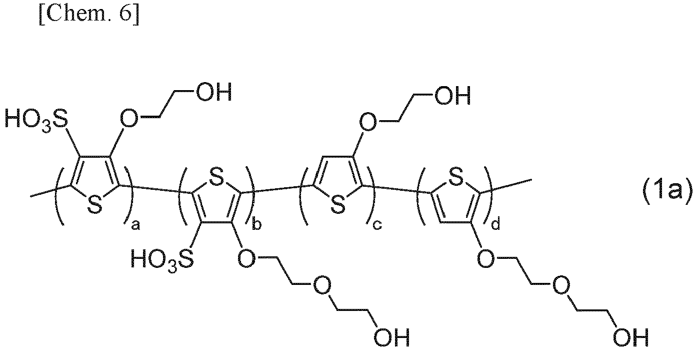

In the formula, a to d represent the molar ratio of each unit, satisfying 0 ≤ a ≤ 1, 0 ≤ b ≤ 1, 0 < a + b ≤ 1, 0 ≤ c <1, 0 ≤ d <1, and a + b + c + d = 1.

Furthermore, the polythiophene derivative may be a homopolymer or a copolymer, including statistical, random, gradient and block copolymers. As the polymer containing a monomer A and a monomer B, a block copolymer includes, for example, an A-B diblock copolymer, an A-B-A triblock copolymer and an (AB)ₘ-multiblock copolymer. The polythiophene may include a repeating unit derived from other types of monomers such as thienothiophene, selenophene, pyrrole, furan, tellurophene, aniline, arylamines, and arylenes such as phenylene, phenylenevinylene and fluorene.

In the present invention, the content of the repeating unit represented by the formula (1) in the polythiophene derivative is preferably more than 50 mol%, more preferably more than 80 mol%, even more preferably more than 90 mol%, further preferably more than 95 mol%, most preferably 100 mol% in the repeating units contained in the polythiophene derivative.

In the present invention, depending on the purity of the starting monomer compound used for polymerization, the polymer to be formed may include a repeating unit derived from impurities. In the present invention, the term "homopolymer" means a polymer including a repeating unit derived from one type of monomer, but may include a repeating unit derived from impurities. In the present invention, the polythiophene derivative is preferably a homopolymer in which basically all repeating units are the repeating unit represented by the formula (1), more preferably a homopolymer including at least one of the repeating units represented by the formulas (1-1) to (1-5).

In the present invention, when the polythiophene derivative includes the repeating unit having a sulfonic acid group, from the viewpoint of further improving the solubility and dispersibility in an organic solvent, an amine compound may be additionally used to form an amine adduct in which the amine compound is added to at least a part of the sulfonic acid group contained in the polythiophene derivative.

The amine compound that can be used for forming the amine adduct include a primary amine compound such as a monoalkylamine compound such as methylamine, ethylamine, n-propylamine, isopropylamine, n-butylamine, isobutylamine, s-butylamine, t-butylamine, n-pentylamine, n-hexylamine, n-heptylamine, n-octylamine, 2-ethylhexylamine, n-nonylamine, n-decylamine, n-undecylamine, n-dodecylamine, n-tridecylamine, n-tetradecylamine, n-pentadecylamine, n-hexadecylamine, n-heptadecylamine, n-octadecylamine, n-nonadecilamine or n-eicosanylamine; or a monoarylamine compound such as aniline, tolylamine, 1-naphthylamine, 2-naphthylamine, 1-anthrylamine, 2-antrhylamine, 9-anthrylamine, 1-phenanthrylamine, 2-phenanthrylamine, 3-phenanthrilamine, 4-phenanthrilamine or 9-phenanthrilamine; a secondary amine compound such as a dialkylamine compound such as N-ethylmethylamine, N-methyl-n-propylamine, N-methylisopropylamine, N-methyl-n-butylamine, N-methyl-s-butylamine, N-methyl-t-butylamine, N-methylisobutylamine, diethylamine, N-ethyl-n-propylamine, N-ethylisopropylamine, N-ethyl-n-butylamine, N-ethyl-s-butylamine, N-ethyl-t-butylamine, dipropylamine, N-n-propylisopropylamine, N-n-propyl-n-butylamine, N-n-propyl-s-butylamine, diisopropylamine, N-n-butylisopropylamine, N-t-butylisopropylamine, di(n-butyl)amine, di(s-butyl)amine, diisobutylamine, aziridine (ethyleneimine), 2-methylaziridine (propyleneimine), 2,2-dimethylaziridine, azetidine (trimethyleneimine), 2-methylazetidine, pyrrolidine, 2-methylpyrrolidine, 3-methylpyrrolidine, 2,5-dimethylpyrrolidine, piperidine, 2,6-dimethylpiperidine, 3,5-dimethylpiperidine, 2,2,6,6-tetramethylpiperidine, hexamethyleneimine, heptamethyleneimine or octamethyleneimine; a diarylamine compound such as diphenylamine, N-phenyl-1-naphthylamine, N-phenyl-2-naphthylamine, 1,1'-dynaphthylamine, 2,2'-dinaphthylamine, 1,2'-dinaphthylamine, carbazole, 7H-benzo[c]carbazole, 11H-benzo[a]carbazole, 7H-dibenzo[c,g]carbazole or 13H-dibenzo[a,i]carbazole; or an alkylarylamine compound such as N-methylaniline, N-ethylaniline, N-n-propylaniline, N-isopropylaniline, N-n-butylaniline, N-s-butylaniline, N-isobutylaniline, N-methyl-1-naphthylamine, N-ethyl-1-naphthylamine, N-n-propyl-1-naphthylamine, indoline, isoindoline, 1,2,3,4-tetrahydroquinoline or 1,2,3,4-tetrahydroisoquinoline; and a tertiary amine compound such as a trialkylamine compound such as N,N-dimethylethylamine, N,N-dimethyl-n-propylamine, N,N-dimethylisopropylamine, N,N-dimethyl-n-butylamine, N,N-dimethyl-s-butylamine, N,N-dimethyl-t-butylamine, N,N-dimethylisobutylamine, N,N-diethylmethylamine, N-methyldi(n-propyl)amine, N-methyldiisopropylamine, N-methyldi(n-butyl)amine, N-methyldiisobutylamine, triethylamine, N,N-diethyl-n-butylamine, N,N-diisopropylethylamine, N,N-di(n-butyl)ethylamine, tri(n-propyl)amine, tri(i-propyl)amine, tri(n-butyl)amine, tri(i-butyl)amine, 1-methylacetidine, 1-methylpyrrolidine or 1-methylpiperidin; a triarylamine compound such as triphenylamine; an alkyldiarylamine compound such as N-methyldiphenylamine, N-ethyldiphenylamine, 9-methylcarbazole or 9-ethylcarbazole; or a dialkylarylamine compound such as N,N-diethylaniline, N,N-di(n-propyl)aniline, N,N-di(i-propyl)aniline or N,N-di(n-butyl)aniline. Among them, taking into consideration of the balance between the solubility of the amine adduct, the charge transportability of the obtained charge-transporting thin film, and the like, a tertiary amine compound is preferable, a trialkylamine compound is more preferable, and triethylamine is even more preferable.

The amine adduct can be obtained by adding a polythiophene derivative to the amine itself or its solution, followed by sufficient stirring.

In the present invention, the polythiophene derivative or an amine adduct thereof treated with a reducing agent may be used.

In the polythiophene derivative or the amine adduct thereof, the chemical structure of some of the composing repeating units may be an oxidized structure called "quinoid structure". The term "quinoid structure" is used in contrast to the term "benzenoid structure". The latter has a structure containing an aromatic ring, while the former means a structure in which a double bond in the aromatic ring moves out of the ring (as a result, the aromatic ring disappears) to form two exocyclic double bonds which are conjugate with another double bond remaining in the ring. Those skilled in the art can easily understand the relationship between these two structures from the relationship between the structures of benzoquinone and hydroquinone. Quinoid structures for repeating units in various conjugated polymers are well known to those skilled in the art. As an example, a quinoid structure corresponding to the repeating unit in the polythiophene derivative represented by the formula (1) is shown in the following formula (1').

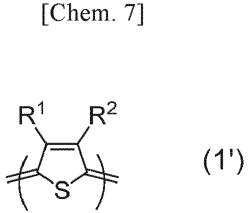

In the formula (1'), R¹ and R² are as defined in the formula (1).

This quinoid structure is generated by a process in which the polythiophene derivative including a repeating unit represented by the formula (1) undergoes an oxidation reaction by a dopant, a so-called doping reaction. The quinoid structure forms a part of structures called a "polaron structure" and a "bipolaron structure" that impart charge transportability to the polythiophene derivative. These structures are publicly known. In the production of organic EL devices, introduction of "polaron structure" and/or "bipolaron structure" is indispensable. In fact, in the production of organic EL devices, when baking a thin film formed from a charge-transporting composition, this introduction is provided by intentionally causing the above doping reaction. It is conceivable that the reason why the polythiophene derivative before causing this doping reaction contains a quinoid structure is because the polythiophene derivative has undergone an unintended oxidation reaction equivalent to the doping reaction in its manufacturing process (particularly the sulfonation step in the process).

There is a correlation between the amount of quinoid structure contained in the polythiophene derivative and the solubility and dispersibility of polythiophene derivative in an organic solvent, and as the amount of quinoid structure increases, the solubility and dispersibility tend to decrease. For this reason, the introduction of the quinoid structure after the thin film is formed from the charge-transporting composition does not cause any problems, but excessive introduction of the quinoid structure into the polythiophene derivative due to the above unintended oxidation reaction may interfere with the production of the charge-transporting composition. It is known that polythiophene derivatives have variations in solubility and dispersibility in an organic solvent. It is conceivable that one of their causes is that the amount of quinoid structure introduced into polythiophene due to the above unintended oxidation reaction varies depending on the difference in the production condition for each polythiophene derivative.

Accordingly, when the polythiophene derivative is subjected to a reduction treatment using a reducing agent, even if the quinoid structure is excessively introduced into the polythiophene derivative, the reduction reduces the amount of quinoid structure, thereby improving the solubility and dispersibility of the polythiophene derivative in an organic solvent. Therefore, it becomes possible to stably produce a good charge-transporting composition capable of giving a thin film excellent in homogeneity.

The conditions for reduction treatment are not particularly limited as long as the quinoid structure can be reduced and appropriately converted into the non-oxidizing structure, that is, the benzenoid structure (for example, in the polythiophene derivative including the repeating unit represented by the formula (1), the quinoid structure represented by the formula (1') is converted into the structure represented by the formula (1)), but this treatment can be performed, for example, by simply contacting the polythiophene derivative or amine adduct with a reducing agent in the presence or absence of a suitable solvent.

Such a reducing agent is also not particularly limited as long as the reduction is appropriately performed, but for example, ammonia water, hydrazine, etc., which are commercially available and easily available, are suitable.

In addition, the amount of reducing agent cannot be unconditionally specified because it differs depending on the type of reducing agent used, but usually, from the viewpoint that the reduction is appropriately performed, the amount is 0.1 parts by weight or more, and from the viewpoint of preventing an excess reducing agent from remaining, the amount is 10 parts by weight or less per 100 parts by weight of the polythiophene derivative or amine adduct to be treated.

In an example of specific methods for reduction treatment, a polythiophene derivative or an amine adduct is stirred in 28% ammonia water at room temperature overnight. By the reduction treatment under such a relatively mild condition, the solubility and dispersibility of the polythiophene derivative and the amine adduct in an organic solvent are sufficiently improved.

When an amine adduct of the polythiophene derivative is used in the charge-transporting composition of the present invention, the reduction treatment may be carried out before the amine adduct is formed or after the amine adduct is formed.

As a result of the change in solubility and dispersibility of the polythiophene derivative or the amine adduct thereof in a solvent by this reduction treatment, the polythiophene derivative or the amine adduct thereof not dissolved in the reaction system at the start of treatment may be dissolved at the completion of treatment. In such a case, the polythiophene derivative or the amine adduct thereof can be recovered by a method including adding an organic solvent incompatible with the polythiophene derivative or the amine adduct thereof (acetone, isopropyl alcohol, etc. in the case of sulfonated polythiophene) to the reaction system to cause precipitation of polythiophene derivative or amine adduct thereof, followed by filtering, or the like.

The weight average molecular weight of the polythiophene derivative represented by the formula (1) or the amine adduct thereof is preferably 1,000 to 1,000,000, more preferably 5,000 to 100,000, even more preferably 10,000 to 50,000. By setting the weight average molecular weight to the lower limit or higher, good conductivity can be achieved with good reproducibility, and by setting the weight average molecular weight to the upper limit or lower, the solubility in a solvent is improved. The weight average molecular weight is a polystyrene conversion value obtained by gel permeation chromatography.

The polythiophene derivative or the amine adduct thereof contained in the charge-transporting composition of the present invention may be only one kind of polythiophene derivative including the repeating unit represented by the formula (1) or amine adduct thereof or two or more kinds thereof.

In addition, as the polythiophene derivative including the repeating unit represented by the formula (1), a commercially available product may be used, or one polymerized by a publicly known method using a thiophene derivative or the like as the starting material may be used. In either case, it is preferable to use a polythiophene derivative purified by a method such as reprecipitation or ion exchange. By using a purified product, the characteristics of an organic EL device provided with the thin film obtained from the composition containing the derivative can be further improved.

Note that sulfonation of conjugated polymers and sulfonated conjugated polymers (including sulfonated polythiophene) are described in US 8,017,241 to Seshadri et al.

In addition, sulfonated polythiophene is described in WO 2008/073149 and WO 2016/171935.

In the present invention, at least a part of the polythiophene derivative including the repeating unit represented by the formula (1) or the amine adduct thereof contained in the charge-transporting composition is dissolved in an organic solvent.

In the present invention, to the extent that the effects of the present invention are not impaired, as the charge-transporting substance, a charge-transporting substance composed of a charge-transporting compound other than the polythiophene derivative including the repeating unit represented by the formula (1) or the amine adduct thereof may be used in combination, without particular limitation, but it is preferable that only the polythiophene derivative including the repeating unit represented by the formula (1) or the amine adduct thereof be contained.

The content of the charge-transporting substance in the charge-transporting composition of the present invention is usually appropriately determined in the range of 0.05 to 40% by weight, preferably 0.1 to 35% by weight per the total weight of the whole composition, taking into consideration of the desired film thickness, viscosity of the composition, etc.

The charge-transporting composition of the present invention contains at least one kind of organosilane compounds selected from fluoroalkyl group-containing silanes and fluoroaryl group-containing silanes.

The fluoroalkyl group includes those similar to the C1-20 fluoroalkyl groups as exemplified above. Among them, the C1-10 fluoroalkyl group is preferable, and the C1-8 fluoroalkyl group is more preferable.

The fluoroaryl group may include groups in which at least one hydrogen atom is substituted with a fluorine atom in the above exemplified C6-20 aryl group, preferably C6-12 aryl group. Examples thereof include, but are not particularly limited to, a 2-fluorophenyl group, a 3-fluorophenyl group, a 4-fluorophenyl group, a 2,3-difluorophenyl group, a 2,4-difluorophenyl group, a 2,5-difluorophenyl group, a 2,6-difluorophenyl group, a 3,4-difluorophenyl group, a 3,5-difluorophenyl group, a 2,3,4-trifluorophenyl group, a 2,3,5-trifluorophenyl group, a 2,3,6-trifluorophenyl group, a 2,4,5-trifluorophenyl group, a 2,4,6-trifluorophenyl group, a 3,4,5-trifluorophenyl group, a 2,3,4,5-tetrafluorophenyl group, a 2,3,4,6-tetrafluorophenyl group, a 2,3,5,6-tetrafluorophenyl group, a perfluorophenyl group, a trifluoromethylphenyl group, a perfluorotolyl group, a 2-fluoro-1-naphthyl group, a 3-fluoro-1-naphthyl group, a 4-fluoro-1-naphthyl group, a 6-fluoro-1-naphthyl group, a 7-fluoro-1-naphthyl group, a 8-fluoro-1-naphthyl group, a 4,5-difluoro-1-naphthyl group, a 5,7-difluoro-1-naphthyl group, a 5,8-difluoro-1-naphthyl group, a 5,6,7,8-tetrafluoro-1-naphthyl group, a heptafluoro-1-naphthyl group, a 1-fluoro-2-naphthyl group, a 5-fluoro-2-naphthyl group, a 6-fluoro-2-naphthyl group, a 7-fluoro-2-naphthyl group, a 5,7-difluoro-2-naphthyl group and a heptafluoro-2-naphthyl group.

The organosilane compound preferably has a fluoroalkyl group or a fluoroaryl group, more preferably has a perfluoroalkyl group and a perfluoroaryl group at the terminal of at least one molecule.

The fluoroalkyl group-containing silanes or fluoroaryl group-containing silanes that can be suitably used in the present invention include, but are not limited to, a fluoroalkyl group-containing silane or a fluoroaryl group-containing silane represented by the following formula (A1) or (B1).

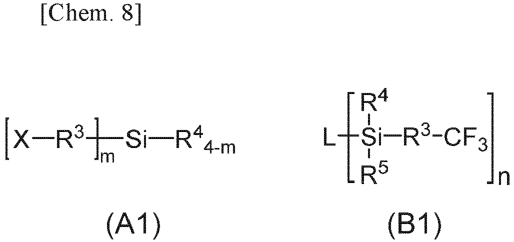

In the formulas, R³s are each independently a single bond, a C1-20 alkylene group, a C6-20 arylene group, an ester bond, an ether bond or a carbonyl bond, R⁴ and R⁵ are each independently a C1-20 alkyl group, a C1-20 alkoxy group or a C1-10 trialkylsilyl group, X is a C1-20 perfluoroalkyl group or a C6-20 perfluoroaryl group, L is O, S or N, m is 1 or 2, and n is 2 or 3.

The C1-20 alkylene group includes those similar to the above exemplified C1-20 alkylene group. Among them, the C1-10 alkylene group is preferable, the C1-5 alkylene group is more preferable, and a methylene group, an ethylene group or a trimethylene group is even more preferable.

Examples of the C6-20 arylene group, preferably the C6-12 arylene group include a phenylene group, a biphenylene group, a naphthylene group and an anthracenylene group. In the present invention, a phenylene group is more preferable.

The C1-20 alkyl group includes those similar to the above exemplified C1-20 alkyl group. Among them, the C1-10 alkyl group is preferable, the C1-5 alkyl group is more preferable, and a methyl group or an ethyl group is even more preferable.

The C1-20 alkoxy group includes those similar to the above exemplified C1-20 alkoxy group. Among them, the C1-10 alkoxy group is preferable, the C1-5 alkoxy group is more preferable, and a methoxy group or an ethoxy group is even more preferable.

The C1-10 trialkylsilyl group includes trialkylsilyl groups in which each alkyl group is a C1-10 alkyl group, preferably C1-5 alkyl groups, such as a trimethylsilyl group, a triethylsilyl group, a tripropylsilyl group, a tributylsilyl group, a tripentylsilyl group, a trihexylsilyl group, a pentyldimethylsilyl group, a hexyldimethylsilyl group, an octyldimethylsilyl group and a decyldimethylsilyl group. In the present invention, a trimethylsilyl group or a triethylsilyl group is preferable.

Examples of the C1-20 perfluoroalkyl group include groups in which all the hydrogen atoms of the C1-20 alkyl group are substituted with fluorine atoms. Among them, the C1-10 perfluoroalkyl group is preferable, and the C1-8 perfluoroalkyl group is more preferable.

Examples of the C6-20 perfluoroaryl group include groups in which all the hydrogen atoms of the C6-20 aryl group are substituted with fluorine atoms. Among them, the C6-12 perfluoroaryl group is preferable, and a perfluorophenyl group or a perfluorotolyl group is more preferable.

L is O, S or N, but O is preferable.

m is 1 or 2, but 1 is preferable.

n, which is a number according to the valence of L, is 2 or 3, but 2 is preferable.

Hereinafter, specific examples of the fluoroalkyl group-containing silanes or fluoroaryl group-containing silanes represented by the formula (A1) or (B1) are given, without particular limitation.

In particular, the fluoroalkyl group-containing silanes represented by the formula (A1-1) are preferable.

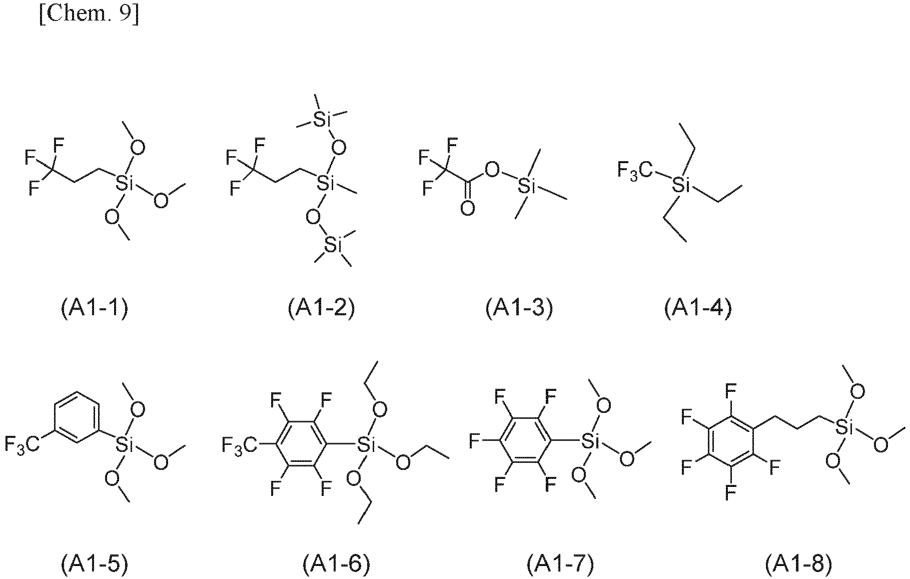

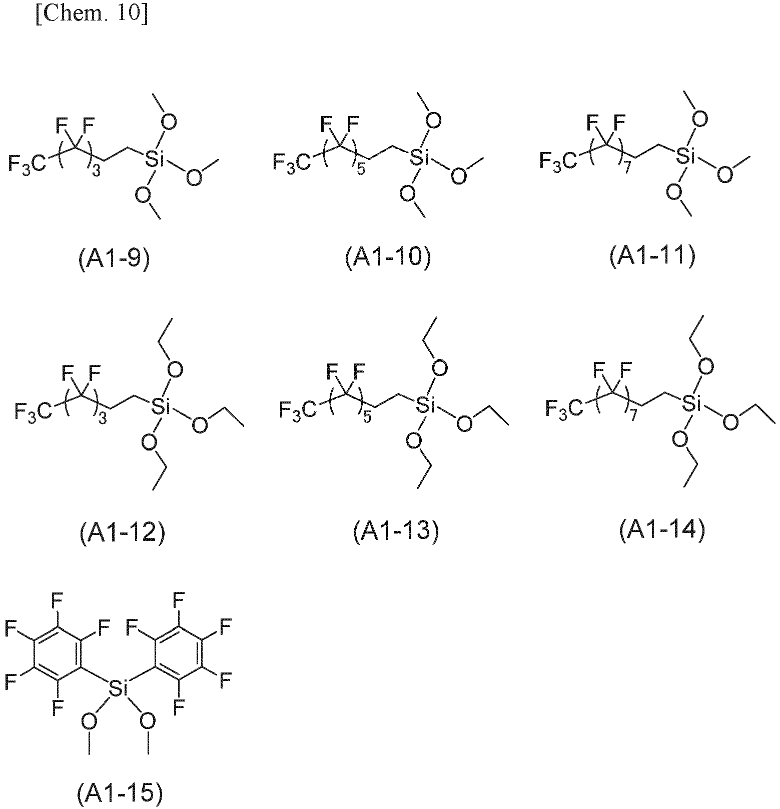

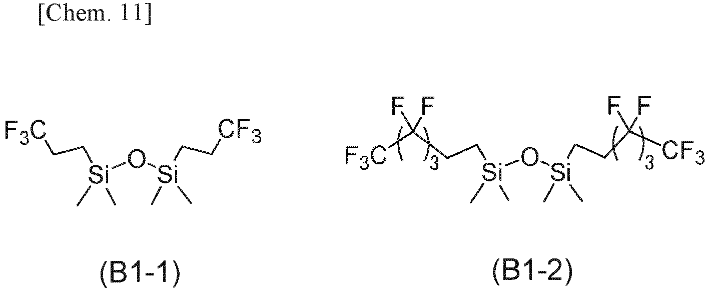

The content of the fluoroalkyl group-containing silane and/or fluoroaryl group-containing silane in the charge-transporting composition of the present invention per the weight of the solid content is usually about 0.1 to 50% by weight in total of the fluoroalkyl group-containing silane and fluoroaryl group-containing silane. Taking into consideration of the balance of improvement of the flatness of the obtained thin film, suppression of the decrease in charge transportability, and the like, the content is preferably about 0.5 to 40% by weight, more preferably about 0.8 to 30% by weight, even more preferably about 1 to 20% by weight.

The organosilane compound used in the present invention can be synthesized by a known method or be available as a commercially available product. Such commercially available products include, but are not limited to, KBM-7103 (manufactured by Shin-Etsu Chemical Co., Ltd.), SIT8365.0 (manufactured by Gelest, Inc.), SIT8618.0 (manufactured by Gelest, Inc.), SIT8356.0 (manufactured by Gelest, Inc.), SIT8343.0 (manufactured by Gelest, Inc.), SIT8345.0 (manufactured by Gelest, Inc.), SIP6716.73 (manufactured by Gelest, Inc.), SIP6716.6 (manufactured by Gelest, Inc.), SIN6597.7 (manufactured by Gelest, Inc.), SIT8176.0 (manufactured by Gelest, Inc.), SIH5841.5 (manufactured by Gelest, Inc.), SIN6597.65 (manufactured by Gelest, Inc.), SIT8175.0 (manufactured by Gelest, Inc.), SIH5841.2 (manufactured by Gelest, Inc.) and SIB1710.0 (manufactured by Gelest, Inc.).

Furthermore, in the charge-transporting composition of the present invention, for the purpose of adjusting the physical properties of the obtained charge-transporting thin film, etc., in addition to the fluoroalkyl group-containing silane and fluoroaryl group-containing silane, another alkoxysilane-based or siloxane-based material may be used in combination.

The other alkoxysilane and/or siloxane-based material may be one kind alone or two or more kinds.

Such another alkoxysilane includes tetraalkoxysilanes such as tetraethoxysilane and tetramethoxysilane; and trialkoxysilanes such as phenyltriethoxysilane, phenyltrimethoxysilane, methyltriethoxysilane, methyltrimethoxysilane and dimethyldiethoxysilane; the tetraalkoxysilanes including dialkoxysilanes such as dimethyldimethoxysilane.

The siloxane-based material includes those obtained by, for example, hydrolyzing fluoroalkyl group-containing silanes and/or fluoroaryl group-containing silanes and/or other silanes. Specific examples thereof include polysiloxanes such as poly(tetraethoxysilane) and poly(phenylethoxysilane).

From the viewpoint of compatibility with the fluoroalkyl group-containing silanes and fluoroaryl group-containing silanes, tetraalkoxysilanes, trialkoxysilanes and dialkoxysilanes are preferable.

When the above other alkoxysilanes are used, the content is not particularly limited as long as the effects of the present invention are not impaired but the above effects are exhibited, but is usually 50% by weight or less per the total weight of the fluoroalkyl group-containing silane and the fluoroaryl group-containing silane.

The charge-transporting composition of the present invention contains metal oxide nanoparticles. The nanoparticles mean fine particles having a mean particle size of primary particles on the order of nanometers (typically 500 nm or less). The metal oxide nanoparticles mean metal oxides that have been formed into nanoparticles.

The primary particle size of the metal oxide nanoparticles used in the present invention is not particularly limited as long as it is nano size, but taking into consideration of reproducible preparation of a thin film having excellent flatness, 2 to 150 nm is preferable, 3 to 100 nm is more preferable, and 5 to 50 nm is even more preferable. Note that the particle size is a value measured using the nitrogen adsorption isotherm obtained by the BET method.

The metal composing the metal oxide nanoparticles in the present invention includes semimetals in addition to metals in the usual sense.

The metals in the usual sense are not particularly limited, but it is preferable to use one or more kinds of metals selected from the group consisting of tin (Sn), titanium (Ti), aluminum (Al), zirconium (Zr), zinc (Zn), niobium (Nb), tantalum (Ta) and tungsten (W).

On the other hand, the semimetals mean elements whose chemical and/or physical properties are intermediate between those of metal and nonmetal. Although a universal definition of semimetal has not been established, in the present invention, a total of 6 elements of boron (B), silicon (Si), germanium (Ge), arsenic (As), antimony (Sb) and tellurium (Te) are used as the semimetals. These semimetals may be used alone or in combination of two or more kinds, and may be used in combination with a metal in the usual sense.

The metal oxide nanoparticles used in the present invention preferably contain oxides of one or more kinds of metals selected from boron (B), silicon (Si), germanium (Ge), arsenic (As), antimony (Sb), tellurium (Te), tin (Sn), titanium (Ti), aluminum (Al), zirconium (Zr), zinc (Zn), niobium (Nb), tantalum (Ta) and tungsten (W). When the metal is a combination of two or more kinds, the metal oxide may be a mixture of individual oxides of independent metals, or may be a complex oxide containing a plurality of metals.

Specific examples of the metal oxide include B₂O₃, B₂O, SiO₂, SiO, GeO₂, GeO, As₂O₄, As₂O₃, As₂O₅, Sb₂O₃, Sb₂O₅, TeO₂, SnO₂, ZrO₂, Al₂O₃ and ZnO. Among them, B₂O₃, B₂O, SiO₂, SiO, GeO₂, GeO, As₂O₄, As₂O₃, As₂O₅, SnO₂, SnO, Sb₂O₃, TeO₂ and a mixture thereof are preferable, and SiO₂ is more preferable.

The metal oxide nanoparticles contained in the charge-transporting composition of the present invention may be one kind alone or two or more kinds.

The metal oxide nanoparticles contained in the charge-transporting composition of the present invention are preferably uniformly dispersed in the composition.

The metal oxide nanoparticles may include one or more kinds of organic capping groups. The organic capping groups may be reactive or non-reactive. Examples of the reactive organic capping groups include organic capping groups that can be crosslinked by UV light or a radical initiator.

In the charge-transporting composition of the present invention, the content of the metal oxide nanoparticles is not particularly limited, but from the viewpoint of suppression of aggregation of the particles in the charge-transporting material, reproducible preparation of a thin film having excellent flatness, etc., 40 to 95% by weight is preferable, 50 to 95% by weight is more preferable, and 60 to 90% by weight is most preferable per the weight of the solid content.

In particular, in the present invention, a composition in which the metal oxide nanoparticles are uniformly dispersed can be prepared with good reproducibility using a sol of metal oxide nanoparticles in which the metal oxide nanoparticles are dispersed.

That is, a charge-transporting composition in which the metal oxide nanoparticles are uniformly dispersed can be produced with good reproducibility by previously preparing a sol of metal oxide nanoparticles, and mixing the sol with a mixture in which a charge-transporting substance or the like is dissolved or dispersed in a solvent, rather than mixing the metal oxide nanoparticles themselves with a charge-transporting substance or the like in a solvent and dispersing them.

Such a sol of metal oxide nanoparticles may be a commercially available product, or may be prepared by a known method using a solvent and metal oxide nanoparticles that the charge-transporting composition of the present invention may contain.

In particular, when preparing the charge-transporting composition of the present invention, it is suitable to use a silica sol in which SiO₂ nanoparticles are dispersed in a dispersion medium.

The silica sol is not particularly limited, and publicly known silica sols can be appropriately selected and used.

Commercially available silica sols are usually in the form of dispersion. Commercially available silica sol includes those in which SiO₂ nanoparticles are dispersed in various solvents, such as water, methanol, methyl ethyl ketone, methyl isobutyl ketone, N,N-dimethylacetamide, ethylene glycol, isopropanol, methanol, ethylene glycol monopropyl ether, cyclohexanone, ethyl acetate, toluene and propylene glycol monomethyl ether acetate.

In particular, in the present invention, a silica sol whose dispersion medium is an alcohol solvent or water is preferable, and a silica sol whose dispersion medium is an alcohol solvent is more preferable. The alcohol solvent is preferably a water-soluble alcohol, more preferably methanol, 2-propanol or ethylene glycol.

Specific examples of the commercially available silica sol includes, but are not limited to, Snowtex (registered trademark) ST-O, ST-OS, ST-O-40 and ST-OL manufactured by Nissan Chemical Corporation, water-dispersed silica sols such as Silicadol 20, 30 and 40 manufactured by Nippon Chemical Industrial Co., Ltd.; and methanol silica sols and organosilica sols such as MA-ST-M, MA-ST-L, IPA-ST, IPA-ST-L, IPA-ST-ZL and EG-ST manufactured by Nissan Chemical Corporation.

The concentration of the silica sol is also not particularly limited, but is preferably 5 to 60% by weight, more preferably 10 to 50% by weight, even more preferably 15 to 30% by weight.

The concentration of SiO₂ nanoparticles in the silica sol is usually about 5 to 50% by weight, but if the concentration of SiO₂ nanoparticles is high, when the silica sol is mixed with a mixture in which a charge-transporting substance or the like is dissolved or dispersed in a solvent, SiO₂ nanoparticles may aggregate depending on the type of solvent contained in the mixture, so it is necessary to keep the above point in mind in preparing the composition.

The charge-transporting composition of the present invention contains an organic solvent.

Such an organic solvent is not particularly limited as long as it disperses or dissolves components other than the organic solvent used in the charge-transporting composition of the present invention.

Specific examples thereof may be appropriately selected from aromatic or halogenated aromatic hydrocarbon solvents such as benzene, toluene, xylene, ethylbenzene and chlorobenzene; aliphatic hydrocarbons such as n-heptane, n-hexane and cyclohexane; ether-based solvents such as diethyl ether, tetrahydrofuran, dioxane and 1,2-dimethoxyethane; ketone-based solvents such as acetone, methyl ethyl ketone, methyl isobutyl ketone and cyclohexanone; ester-based solvents such as ethyl acetate, normal hexyl acetate, ethyl lactate and γ-butyrolactone; halogenated hydrocarbon solvents such as methylene chloride, dichloromethane, 1,2-dichloroethane and chloroform; amide-based solvents such as N,N-dimethylformamide, N,N-dimethylacetamide, N-methyl-2-pyrrolidone and 1,3-dimethyl-2-imidazolidinone; alcohol-based solvents such as methanol, ethanol, isopropanol, n-propanol, cyclohexanol, diacetone alcohol and 2-benzooxyethanol; glycol ether-based solvents such as ethylene glycol monoethyl ether, ethylene glycol monobutyl ether, ethylene glycol diglycidyl ether, propylene glycol monomethyl ether, diethylene glycol monomethyl ether, diethylene glycol monoethyl ether, diethylene glycol diethyl ether, diethylene glycol dimethyl ether, triethylene glycol dimethyl ether, diethylene glycol monoethyl ether acetate, diethylene glycol monobutyl ether acetate, dipropylene glycol monomethyl ether and propylene glycol monomethyl ether acetate; and glycol-based solvents such as ethylene glycol, propylene glycol, hexylene glycol, 1,3-octylene glycol, diethylene glycol, dipropylene glycol, triethylene glycol, tripropylene glycol, 1,3-butanediol, 2,3-butanediol and 1,4-butanediol.

In addition, these organic solvents can be used alone or in combination of two or more kinds.

The charge-transporting composition of the present invention may also contain water as a solvent, but from the viewpoint of reproducible preparation of an organic EL device having excellent durability, the content of water is preferably 10% by weight or less, more preferably 5% by weight or less per the weight of the whole solvent. It is optimal to use only an organic solvent as the solvent. The "only an organic solvent" in this case means that used as the solvent is only an organic solvent, but does not deny even the presence of "water" contained in a trace amount in the used organic solvent, solid content or the like.

The charge-transporting composition of the present invention may contain a dopant substance for the purpose of, for example, improving the charge transporting ability, depending on the use of the obtained thin film.

The dopant substance is not particularly limited as long as it is soluble in at least one kind of solvents used in the composition, but either an inorganic dopant substance or an organic dopant substance may be used.

The inorganic dopant substance includes heteropoly acids such as phosphomolybdic acid, silicomolybdic acid, phosphotungstic acid, phosphotungstic/molybdic acid and silicotungstic acid; inorganic strong acids such as hydrogen chloride, sulfuric acid, nitric acid and phosphoric acid; metal halides such as aluminum (III) chloride (AlCl₃), titanium (IV) tetrachloride (TiCl₄), boron tribromide (BBr₃), boron trifluoride ether complex (BF₃·OEt₂), iron (III) chloride (FeCl₃), copper (II) chloride (CuCl₂), antimony (V) pentachloride (SbCl₅), arsenic (V) pentafluoride (AsF₅) and phosphorus pentafluoride (PF₅), and halogens such as Cl₂, Br₂, I₂, ICl, ICl₃, IBr and IF₄.

In addition, the organic dopant substance includes tetracyanoquinodimethanes such as 7,7,8,8-tetracyanoquinodimethane (TCNQ), 2-fluoro-7,7,8,8-tetracyanoquinodimethane and 2,5-difluoro-7,7,8,8-tetracyanoquinodimethane; halotetracyanoquinodimethanes (Halo TCNQs) such as tetrafluoro-7,7,8,8-tetracyanoquinodimethane (F4TCNQ), tetrachloro-7,7,8,8-tetracyanoquinodimethane, 2-fluoro-7,7,8,8-tetracyanioquinodimethane, 2-chloro-7,7,8,8-tetracyanoquinodimethane, 2,5-difluoro-7,7,8,8-tetracyanoquinodimethane and 2,5-dichloro-7,7,8,8-tetracyanoquinodimethane; benzoquinone derivatives such as tetrachloro-1,4-benzoquinone (chloranil) and 2,3-dichloro-5,6-dicyano-1,4-benzoquinone (DDQ); arylsulfonic acid compounds such as benzenesulfonic acid, tosylic acid, p-styrenesulfonic acid, 2-naphthalenesulfonic acid, 4-hydroxybenzenesulfonic acid, 5-sulfosalicylic acid, p-dodecylbenzene sulfonic acid, dihexylbenzene sulfonic acid, 2,5-dihexylbenzene sulfonic acid, dibutylnaphthalene sulfonic acid, 6,7-dibutyl-2-naphthalene sulfonic acid, dodecyl naphthalene sulfonic acid, 3-dodecyl-2-naphthalene sulfonic acid, hexylnaphthalene sulfonic acid, 4-hexyl-1-naphthalene sulfonic acid, octylnaphthalene sulfonic acid, 2-octyl-1-naphthalene sulfonic acid, hexylnaphthalene sulfonic acid, 7-hexyl-1-naphthalene sulfonic acid, 6-hexyl-2-naphthalene sulfonic acid, dinonylnaphthalene sulfonic acid, 2,7-dinonyl-4-naphthalene sulfonic acid, dinonylnaphthalene disulfonic acid, 2,7-dinonyl-4,5-naphthalene disulfonic acid, 1,4-benzodioxan disulfonic acid derivatives described in WO 2005/000832, aryl sulfonic acid derivatives described in WO 2006/025342 and dinonylnaphthalene sulfonic acid derivatives described in JP-A 2005-108828; aromatic sulfone compounds such as polystyrene sulfonic acid; and non-aromatic sulfone compounds such as 10-camphorsulfonic acid.

One kind of these inorganic and organic dopant substances may be used alone, or two or more kinds thereof may be used in combination.

Examples of the aryl sulfonic acid compound preferable as the dopant substance in the present invention include the aryl sulfonic acid compound represented by the formula (HI) or (H2).

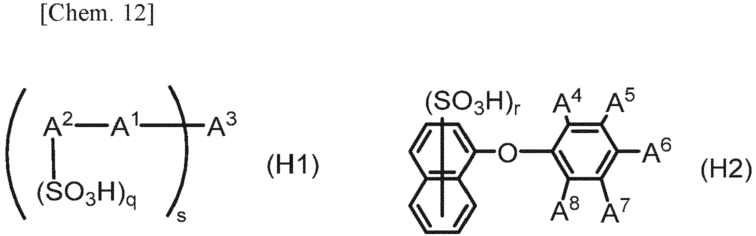

A¹ represents O or S, but O is preferable.

A² represents a naphthalene ring or an anthracene ring, but a naphthalene ring is preferable.

A³ represents a bivalent to tetravalent perfluorobiphenyl group, and s indicates the number of bonds between A¹ and A³, and is an integer satisfying 2 ≤ s ≤ 4, but it is preferable that A³ be a perfluorobiphenyldiyl group, preferably a perfluorobiphenyl-4,4'-diyl group, and s be 2.

q represents the number of sulfonic acid groups bonded to A², and is an integer satisfying 1 ≤ q ≤ 4, but 2 is optimal.

A⁴ to A⁸ each independently represent a hydrogen atom, a halogen atom, a cyano group, a C1-20 alkyl group, a C1-20 halogenated alkyl group or a C2-20 halogenated alkenyl group, provided that at least three of A⁴ to A⁸ are halogen atoms.

The C1-20 halogenated alkyl group includes a trifluoromethyl group, a 2,2,2-trifluoroethyl group, a 1,1,2,2,2-pentafluoroethyl group, a 3,3,3-trifluoropropyl group, a 2,2,3,3,3-pentafluoropropyl group, a 1,1,2,2,3,3,3-heptafluoropropyl group, a 4,4,4-trifluorobutyl group, a 3,3,4,4,4-pentafluorobutyl group, a 2,2,3,3,4,4,4-heptafluorobutyl group and a 1,1,2,2,3,3,4,4,4-nonafluorobutyl group.

The C2-20 halogenated alkenyl group includes a perfluorovinyl group, a perfluoropropenyl group (allyl group) and a perfluorobutenyl group.

Other examples of the halogen atom and the C1-20 alkyl group include those similar to the above, but the halogen atom is preferably a fluorine atom.

Among them, it is preferable that A⁴ to A⁸ be a hydrogen atom, a halogen atom, a cyano group, a CI-10 alkyl group, a C1-10 halogenated alkyl group or a C2-10 halogenated alkenyl group, and at least three of A⁴ to A⁸ be fluorine atoms, it is more preferable that A⁴ to A⁸ be a hydrogen atom, a fluorine atom, a cyano group, a C1-5 alkyl group, a C1-5 fluorinated alkyl group or a C2-5 fluorinated alkenyl group, and at least three of A⁴ to A⁸ be fluorine atoms, and it is even more preferable that A⁴ to A⁸ be a hydrogen atom, a fluorine atom, a cyano group, a C1-5 perfluoroalkyl group or a C1-5 perfluoroalkenyl group, and A⁴, A⁵ and A⁸ be fluorine atoms.

Note that the perfluoroalkyl group is a group in which all the hydrogen atoms of the alkyl group are substituted with fluorine atoms, and the perfluoroalkenyl group is a group in which all the hydrogen atoms of the alkenyl group are substituted with fluorine atoms.

r represents the number of sulfonic acid groups bonded to the naphthalene ring, and is an integer satisfying 1 ≤ r ≤ 4, but 2 to 4 is preferable, and 2 is optimal.

When an organic compound is used as the dopant substance, its molecular weight is preferably 3,000 or less, more preferably 2,500 or less, taking into consideration of the solubility in an organic solvent.

In particular, the molecular weight of an aryl sulfonic acid compound used as the dopant substance is not particularly limited, but is preferably 2,000 or less, more preferably 1,500 or less, taking into consideration of the solubility in an organic solvent.

Examples of the aryl sulfonic acid compound that can be suitably used in the present invention include, but are not limited to, the following compounds.

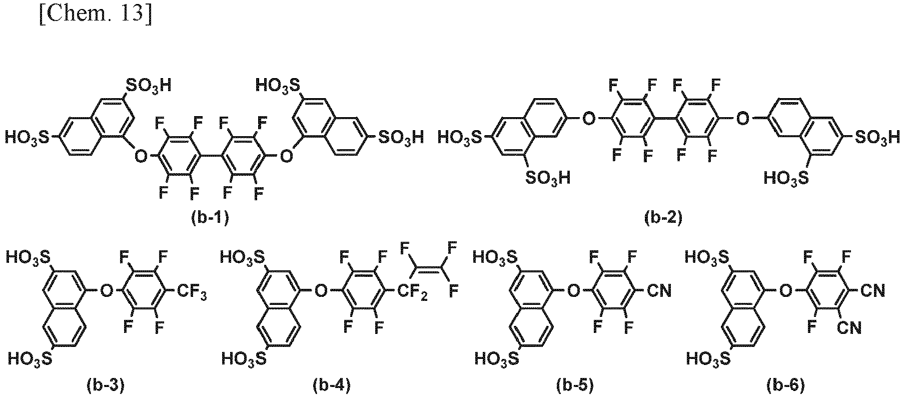

The charge-transporting composition of the present invention may contain an amine compound for the purpose of, for example, improving the dispersibility and solubility of the polythiophene derivative or the amine adduct thereof.

Such an amine compound is not particularly limited as long as it is soluble in at least one solvent used in the composition, and may be one kind alone or two or more kinds.

Specific examples of the primary amine compound include monoalkylamine compounds such as methylamine, ethylamine, n-propylamine, isopropylamine, n-butylamine, isobutylamine, s-butylamine, t-butylamine, n-pentylamine, n-hexylamine, n-heptylamine, n-octylamine, 2-ethylhexylamine, n-nonylamine, n-decylamine, n-undecylamine, n-dodecylamine, n-tridecylamine, n-tetradecylamine, n-pentadecylamine, n-hexadecylamine, n-heptadecylamine, n-octadecylamine, n-nonadecilamine and n-eicosanylamine; and monoarylamine compounds such as aniline, tolylamine, 1-naphthylamine, 2-naphthylamine, 1-anthrylamine, 2-anthrylamine, 9-anthrylamine, 1-phenanthrylamine, 2-phenanthrylamine, 3-phenanthrylamine, 4-phenanthrylamine and 9-phenanthrylamine.

Specific examples of the secondary amine compound include dialkylamine compounds such as N-ethylmethylamine, N-methyl-n-propylamine, N-methylisopropylamine, N-methyl-n-butylamine, N-methyl-s-butylamine, N-methyl-t-butylamine, N-methylisobutylamine, diethylamine, N-ethyl-n-propylamine, N-ethylisopropylamine, N-ethyl-n-butylamine, N-ethyl-s-butylamine, N-ethyl-t-butylamine, dipropylamine, N-n-propylisopropylamine, N-n-propyl-n-butylamine, N-n-propyl-s-butylamine, diisopropylamine, N-n-butylisopropylamine, N-t-butylisopropylamine, di(n-butyl)amine, di(s-butyl)amine, diisobutylamine, aziridine (ethyleneimine), 2-methylaziridine (propyleneimine), 2,2-dimethylaziridine, azetidine (trymethyleneimine), 2-methylazetidine, pyrrolidine, 2-methylpyrrolidine, 3-methylpyrrolidin, 2,5-dimethylpyrrolidine, piperidine, 2,6-dimethylpiperidine, 3,5-dimethylpiperidine, 2,2,6,6-tetramethylpiperidine, hexamethyleneimine, heptamethyleneimine and octamethyleneimine; diarylamine compounds such as diphenylamine, N-phenyl-1-naphthylamine, N-phenyl-2-naphthylamine, 1,1'-dinaphthylamine, 2,2'-dinaphthylamine, 1,2'-dinaphthylamine, carbazole, 7H-benzo [c] carbazole, 11H-benzo[a]carbazole, 7H-dibenzo[c,g]carbazole and 13H-dibenzo[a,i]carbazole; and alkylarylamine compounds such as N-methylaniline, N-ethylaniline, N-n-propylaniline, N-isopropylaniline, N-n-butylaniline, N-s-butylaniline, N-isobutylaniline, N-methyl-1-naphthylamine, N-ethyl-1-naphthylamine, N-n-propyl-1-naphthylamine, indoline, isoindoline, 1,2,3,4-tetrahydroquinoline and 1,2,3,4-tetrahydroisoquinoline.

Specific examples of the tertiary amine compound include trialkylamine compounds such as N,N-dimethylethylamine, N,N-dimethyl-n-propylamine, N,N-dimethylisopropylamine, N,N-dimethyl-n-butylamine, N,N-dimethyl-s-butylamine, N,N-dimethyl-t-butylamine, N,N-dimethylisobutylamine, N,N-diethylmethylamine, N-methyldi(n-propyl)amine, N-methyldiisopropylamine, N-methyldi(n-butyl)amine, N-methyldiisobutylamine, triethylamine, N,N-diethyl-n-butylamine, N,N-diisopropyl ethyl amine, N,N-di(n-butyl)ethylamine, tri(n-propyl)amine, tri(i-propyl)amine, tri(n-butyl)amine, tri(i-butyl)amine, 1-methylacetidine, 1-methylpyrrolidine and 1-methylpiperidin; triarylamine compounds such as triphenylamine; alkyldiarylamine compounds such as N-methyldiphenylamine, N-ethyldiphenylamine, 9-methylcarbazole and 9-ethylcarbazole; and dialkylarylamine compounds such as N,N-diethylaniline, N,N-di(n-propyl)aniline, N,N-di(i-propyl)aniline and N,N-di(n-butyl)aniline.

Among them, when the charge-transporting composition of the present invention contains an amine compound, the amine compound preferably contains a primary amine compound, preferably a monoalkylamine, particularly a C2-20 monoalkylamine, because it is excellent in the ability to improve the dispersibility and solubility of the polythiophene derivative or the amine adduct thereof used in the present invention.

When the charge-transporting composition of the present invention contains an amine compound, its content is usually 200% by weight or less per the weight of the polythiophene derivative or the amine adduct thereof used in the present invention, but in order to obtain the above effects by the amine compound, 50% by weight or more is preferable.

The viscosity of the charge-transporting composition of the present invention is usually 1 to 50 mPa·s at 25°C, and the surface tension is usually 20 to 50 mN/m at 25°C.

The viscosity and surface tension of the charge-transporting composition of the present invention can be adjusted by changing, for example, the type and ratio of organic solvent used or solid content concentration, taking into consideration of various factors such as the coating method used and the desired film thickness.

In addition, the solid content concentration of the charge-transporting composition in the present invention, which is appropriately set in consideration of the viscosity and surface tension of the composition, the thickness of the thin film to be produced, etc., is usually about 0.1 to 15.0% by weight. From the viewpoint of, for example, suppression of aggregation of the charge-transporting substance or metal oxide nanoparticles in the composition, the solid content concentration is preferably 10.0% by weight or less, more preferably 8.0% by weight or less, even more preferably 5% by weight or less.

The charge-transporting composition of the present invention can be produced by mixing the polythiophene derivative including the repeating unit represented by the formula (1) or the amine adduct thereof, at least one kind of organosilane compounds selected from the fluoroalkyl group-containing silanes and fluoroaryl group-containing silanes, the metal oxide nanoparticles, and the organic solvent.

The mixing order is not particularly limited, but an example of a method capable of easily producing the charge-transporting composition of the present invention with good reproducibility includes a method including mixing the polythiophene derivative including the repeating unit represented by the formula (1) or the amine adduct thereof, the fluoroalkyl group-containing silane, the fluoroaryl group-containing silane and the like with an organic solvent to prepare a mixture, and adding to the mixture the previously prepared sol of metal oxide nanoparticles, and a method including adding the mixture to the previously prepared sol of metal oxide nanoparticles. In this case, if necessary, an additional organic solvent may be added at the end, or some components that are relatively soluble in the solvent may not be included in the mixture but added at the end, but from the viewpoint of suppression of aggregation and separation of constituents and reproducible preparation of the charge-transporting composition having excellent uniformity, it is preferable to separately prepare the sol of metal oxide nanoparticles in a well-dispersed or well-dissolved state and the mixture containing the other components, and mix both of them, followed by sufficient stirring. It should be noted that the metal oxide nanoparticles, and the polythiophene derivative or the amine adduct thereof may aggregate or precipitate when mixed depending on the kind and amount of solvent to be mixed together. It should be also noted that when preparing the composition using the sol, it is necessary to determine the concentration and the amount of the sol used such that the amount of metal oxide nanoparticles in the finally obtained composition becomes a desired amount.

In preparation of the composition, heating may be appropriately performed as long as the component is not decomposed or deteriorated.

In the present invention, for the purpose of preparing a thin film having higher flatness with good reproducibility, the charge-transporting composition may be filtered in the middle of producing the composition or after mixing all the components using a filter on the order of submicrometers or the like.

By applying and baking the charge-transporting composition of the present invention described above on a substrate, the charge-transporting thin film of the present invention can be formed on the substrate.

The method for applying the composition includes, but is not particularly limited to, a dip method, a spin coating method, a transfer printing method, a roll coating method, brush coating, an inkjet method, a spray method and a slit coating method. Depending on the coating method, it is preferable to adjust the viscosity and surface tension of the composition.

In addition, when the charge-transporting composition of the present invention is used, the baking atmosphere is not particularly limited, and not only in the air atmosphere, but also in an inert gas such as nitrogen or in a vacuum, a thin film having a uniform film formation surface and high charge transportability can be obtained.

The baking temperature is appropriately set within the range of about 100 to 260°C, in consideration of the application of the obtained thin film, the degree of charge transportability given to the obtained thin film, the type and boiling point of solvent, etc., but when the obtained thin film is used as a hole injection layer for an organic EL device, the baking temperature is preferably about 140 to 250°C, more preferably about 145 to 240°C.

Note that, during baking, for the purpose of expressing a higher uniform film formation property or advancing the reaction on a substrate, the temperature may be changed in two or more steps, and heating may be performed, for example, using an appropriate device such as a hot plate or an oven.

The film thickness of the charge-transporting thin film is not particularly limited, but when used as a hole injection layer or a hole transport layer of an organic EL device, the film thickness is usually 3 to 300 nm, preferably 5 to 200 nm. The method for changing the film thickness includes a method including changing the solid content concentration in the composition or a method including changing the amount of the composition on a substrate at the time of application.

The organic EL device of the present invention has a pair of electrodes, and has a functional film made of the charge-transporting thin film of the present invention between these electrodes.

Typical configurations of the organic EL device include, but are not limited to, the following (a) to (f). In the following configurations, if necessary, the electron block layer or the like may be provided between the light emitting layer and the anode, and the hole block layer or the like may be provided between the light emitting layer and the cathode. In addition, the hole injection layer, the hole transport layer, or the hole injection transport layer may also have a function as the electron block layer or the like, and the electron injection layer, the electron transport layer, or the electron injection transport layer may also have a function as the hole block layer or the like. Furthermore, it is also possible to provide any functional layer between the respective layers, if necessary.
(a) Anode/hole injection layer/hole transport layer/light emitting layer/electron transport layer/electron injection layer/cathode
(b) Anode/hole injection layer/hole transport layer/light emitting layer/electron injection transport layer/cathode
(c) Anode/hole injection transport layer/light emitting layer/electron transport layer/electron injection layer/cathode
(d) Anode/hole injection transport layer/light emitting layer/electron injection transport layer/cathode
(e) Anode/hole injection layer/hole transport layer/light emitting layer/cathode
(f) Anode/hole injection transport layer/light emitting layer/cathode

As to the "hole injection layer", "hole transport layer" and "hole injection transport layer", a layer is the "hole injection transport layer" formed between the light emitting layer and the anode, having the function of transporting holes from the anode to the light emitting layer, and having only one layer of hole transporting material provided between the light emitting layer and the anode, a layer is the "hole injection layer" close to the anode when two or more layers of hole transporting material are provided between the light emitting layer and the anode, and the other layer is the "hole transport layer". In particular, as the hole injection (transport) layer, a thin film is used excellent in not only hole acceptability from the anode but also hole injection property into the hole transport (light emitting) layer.

As to the "electron injection layer", "electron transport layer" and "electron injection transport layer", a layer is the "electron injection transport layer" formed between the light emitting layer and the cathode, having the function of transporting electrons from the cathode to the light emitting layer, and having only one layer of electron transporting material provided between the light emitting layer and the cathode, a layer is the "electron injection layer" close to the cathode when two or more layers of electron transporting material are provided between the light emitting layer and the cathode, and the other layer is the "electron transport layer".

The "light emitting layer" is an organic layer having a light emitting function, and contains a host material and a dopant material when a doping system is adopted. In this case, the host material mainly has a function of promoting a recombination of electrons and holes and confining excitons in the light emitting layer, and the dopant material has a function of efficiently emitting light by the excitons obtained by the recombination. In the case of a phosphorescent device, the host material mainly has a function of confining excitons generated by the dopant in the light emitting layer.

A charge-transporting thin film prepared from the charge-transporting composition of the present invention may be used in organic EL devices as the functional layer formed between the anode and the light emitting layer, suitably used for the hole injection layer, hole transport layer and hole injection transport layer, more suitably used for the hole injection layer.

The materials used and methods for producing an organic EL device using the charge-transporting composition of the present invention include, but are not limited to, the following.

An example of the method for producing an OLED device having the hole injection layer made of a thin film obtained from the charge-transporting composition is as follows. Note that it is preferable that electrodes be preliminarily cleaned with alcohol, pure water or the like, or surface-treated by UV ozone treatment, oxygen-plasma treatment or the like, without adversely affecting the electrodes.

The hole injection layer is formed on an anode substrate by the above method using the charge-transporting composition. The formed hole injection layer thereon is introduced into a vacuum vapor deposition apparatus, and the hole transport layer, light emitting layer, electron transport layer/hole block layer, electron injection layer and cathode metal are sequentially vapor-deposited. Alternatively, instead of forming the hole transport layer and light emitting layer by vapor deposition in the method, these layers are formed by a wet process using a composition for forming a hole transport layer containing a hole transporting polymer and a composition for forming a light emitting layer containing a light emitting polymer. If necessary, the electron blocking layer may be provided between the light emitting layer and the hole transport layer.

The anode material includes transparent electrodes typified by indium tin oxide (ITO) and indium zinc oxide (IZO), metals typified by aluminum, or metal anodes composed of alloys thereof or the like, and those that have been flattened are preferable. A polythiophene derivative or a polyaniline derivative having a high charge transportability can also be used.

Another metal composing the metal anode includes, but is not limited to, gold, silver, copper, indium, and alloys thereof.

The material for forming the hole transport layer includes (triphenylamine) dimer derivatives, a [(triphenylamine)dimer]spirodimer, N,N'-bis(naphthalen-1-yl)-N,N'-bis(phenyl)-benzidine (a-NPD), triarylamines such as 4,4',4"-tris[3-methylphenyl(phenyl)amino]triphenylamine (m-MTDATA) and 4,4',4"-tris[1-naphthyl(phenyl)amino]triphenylamine (1-TNATA), and oligothiophenes such as 5,5"-bis-{4-[bis(4-methylphenyl)amino]phenyl}-2,2':5',2"-terthiophene (BMA-3T).

The material for forming the light emitting layer includes, but is not limited to, low molecular weight light emitting materials such as metal complexes such as an aluminum complex of 8-hydroxyquinoline, metal complexes of 10-hydroxybenzo[h]quinoline, bisstyrylbenzene derivatives, bisstyrylallylene derivatives, metal complexes of (2-hydroxyphenyl)benzothiazole and silole derivatives; and systems in which a light emitting material and an electron transfer material are mixed with a high molecular compound such as poly(p-phenylene vinylene), poly[2-methoxy-5-(2-ethylhexyloxy)-1,4-phenylene vinylene], poly(3-alkylthiophene) or polyvinylcarbazole.

When forming the light emitting layer by vapor deposition, a light emitting dopant may be co-deposited. The light emitting dopant includes, but is not limited to, metal complexes such as tris(2-phenylpyridine)iridium (III) (Ir(ppy)₃), naphthacene derivatives such as rubrene, quinacridone derivatives and condensed polycyclic aromatic rings such as perylene.

The material for forming the electron transport layer/hole block layer includes, but is not limited to, oxydiazole derivatives, triazole derivatives, phenanthroline derivatives, phenylquinoxaline derivatives, benzimidazole derivatives and pyrimidine derivatives.

The material for forming the electron injection layer includes, but is not limited to, metal oxides such as lithium oxide (Li₂O), magnesium oxide (MgO) and alumina (Al₂O₃), and metal fluorides such as lithium fluoride (LiF) and sodium fluoride (NaF).

The cathode material includes, but is not limited to, aluminum, a magnesium-silver alloy and an aluminum-lithium alloy.

The material for forming the electron block layer includes, but is not limited to, tris(phenylpyrazole)iridium.

The hole transporting polymer includes poly[(9,9-dihexylfluorenyl-2,7-diyl)-co-(N,N'-bis{p-butylphenyl}-1,4-diaminophenylene)], poly[(9,9-dioctylfluorenyl-2,7-diyl)-co-(N,N'-bis{p-butylphenyl}-1,1'-biphenylene-4,4-diamine)], poly[(9,9-bis{1'-pentene-5'-yl}fluorenyl-2,7-diyl)-co-(N,N'-bis{p-butylphenyl}-1,4-diaminophenylene)], poly[N,N'-bis(4-butylphenyl)-N,N'-bis(phenyl)-benzidine]-endcapped with polysilsesquioxane and poly[(9,9-didioctylfluorenyl-2,7-diyl)-co-(4,4'-(N-(p-butylphenyl))diphenylamine)].

The light emitting polymer includes polyfluorene derivatives such as poly(9,9-dialkylfluorene) (PDAF), polyphenylene vinylene derivatives such as poly(2-methoxy-5-(2'-ethylhexoxy)-1,4-phenylene vinylene) (MEH-PPV), polythiophene derivatives such as poly(3-alkylthiophene) (PAT) and polyvinylcarbazole (PVCz).

Because the materials composing the anode and the cathode, and the layer formed between them differ depending on whether a device having the bottom mission structure or the top emission structure is produced, the material is appropriately selected in consideration of this point.

Usually, in devices having the bottom emission structure, a transparent anode is used on the substrate side, and light is taken out from the substrate side, whereas in devices having the top emission structure, a reflective anode made of metal is used, and light is taken out from the transparent electrode (cathode) side, the opposite side to the substrate. Accordingly, for example, as to anode materials, a transparent anode such as ITO is used when devices having the bottom emission structure are produced, whereas a reflective anode such as Al/Nd is used when devices having the top emission structure are produced.

In order to prevent deterioration of characteristics, the organic EL device of the present invention may be sealed with a water catching agent or the like, if necessary, in accordance with the usual method.

As described above, the charge-transporting composition of the present invention is suitably used to form the hole injection layer or the hole transport layer of organic EL devices. Besides, the charge-transporting composition can also be used to form the charge-transporting thin film in electronic devices such as organic photoelectric conversion devices, organic thin film solar cells, organic perovskite photoelectric conversion devices, organic integrated circuits, organic field effect transistors, organic thin film transistors, organic light emitting transistors, organic optical inspection devices, organic photoreceptors, organic electric field quenchers, luminescent electrochemical cells, quantum dot light emitting diodes, quantum lasers, organic laser diodes and organic plasmon light emitting devices.

### EXAMPLES

Hereinafter, a specific description is made of the present invention with reference to Examples and Comparative Examples, but the present invention is not limited to the following Examples. The equipment used is as follows.
(1) Substrate cleaning:
   Substrate cleaning apparatus (reduced pressure plasma type) manufactured by Choshu Industry Co., Ltd.
(2) Application of composition:
   Spin Coater MS-A100 manufactured by Mikasa Co., Ltd.
(3) Measurement of film thickness:
   fine shape measuring machine Surf Coder ET-4000 manufactured by Kosaka Laboratory Ltd.
(4) Production of EL device:
   Multi-function vapor deposition apparatus System C-E2L1G1-N manufactured by Choshu Industry Co., Ltd.
(5) Measurement of luminance, etc. of EL device:
   I-V-L Measurement System manufactured by Tech World, Ltd.

### [1] Synthesis of compound

### [Example of synthesis 1] Synthesis of polythiophene derivative

With 0.9 g of triethylamine was mixed 500 g of an aqueous dispersion of a polythiophene derivative (concentration of 0.6% by weight) which was a polymer including a repeating unit represented by the formula (1a), and the obtained mixture was evaporated to dryness by rotary evaporation. Then, the obtained dried product was further dried in a vacuum oven at 50°C overnight to yield 4 g of a polythiophene derivative A having an amine added to the sulfonic acid group.

### [2] Preparation of charge-transporting composition

### [Example 1-1]

With 0.941 g of ethylene glycol (EG) and 1.930 g of diethylene glycol (DEG) were mixed 0.030 g of polythiophene derivative A and 0.048 g of 2-ethylhexylamine (2-EHA), followed by stirring at 80°C for 1 hour using a hot stirrer. To the resulting mixture was added 0.965 g of 2-benzooxyethanol (2-BOE) and 4.826 g of triethylene glycol dimethyl ether (TEGDME). To this were added 1.244 g of an organosilica sol EG-ST (manufactured by Nissan Chemical Corporation, 20.5% by weight, the same applies hereinafter) containing ethylene glycol as the dispersion medium containing SiO₂, which was metal oxide nanoparticles, and 0.015 g of an organosilane compound represented by the formula (A1-1) (KBM-7103, manufactured by Shin-Etsu Chemical Co., Ltd.), followed by stirring. The resulting mixture was filtered through a PP syringe filter having a pore size of 0.2 µm to prepare a charge-transporting composition.

### [Example 1-2]

First, a 10% by weight solution of aryl sulfonic acid represented by the formula (b-1) (aryl sulfonic acid B) in ethylene glycol was prepared. The solution was prepared using a hot stirrer and stirred at 400 rpm and 50°C for 1 hour.

Next, another container was prepared to mix 0.030 g of polythiophene derivative A and 0.048 g of 2-EHA with 0.788 g of EG and 1.930 g of DEG, followed by stirring at 80°C for 1 hour using a hot stirrer. To the resulting mixture were added 0.965 g of 2-BOE and 4.826 g of TEGDME, followed by stirring. To this were added 0.300 g of a 10% by weight solution of aryl sulfonic acid B in ethylene glycol, 1.098 g of EG-ST and 0.015 g of KBM-7103, followed by stirring. The resulting mixture was filtered through a PP syringe filter having a pore size of 0.2 µm to prepare a charge-transporting composition.

Note that the aryl sulfonic acid represented by the formula (b-1) was synthesized in accordance with WO 2006/025342 (the same applies hereinafter).

The 10% by weight solution of aryl sulfonic acid B in ethylene glycol was also used in Comparative Example 1-2.

### [Example 1-3]

With 0.941 g of EG and 1.930 g of DEG were mixed 0.030 g of polythiophene derivative A and 0.048 g of 2-EHA, followed by stirring at 80°C for 1 hour using a hot stirrer. To the resulting mixture were added 0.965 g of 2-BOE and 4.826 g of TEGDME To this were added 1.244 g of EG-ST and 0.015 g of an organosilane compound represented by the formula (A1-8) (SIP6716.6, manufactured by Gelest, Inc.), followed by stirring. The resulting mixture was filtered through a PP syringe filter having a pore size of 0.2 µm to prepare a charge-transporting composition.

### [Comparative Example 1-1]

With 0.883 g of EG and 1.930 g of DEG were mixed 0.030 g of polythiophene derivative A and 0.048 g of 2-EHA, followed by stirring at 80°C for 1 hour using a hot stirrer. To the resulting mixture were added 0.965 g of 2-BOE and 4.826 g of TEGDME, followed by stirring. To this was added 1.317 g of EG-ST, followed by stirring. The resulting mixture was filtered through a PP syringe filter having a pore size of 0.2 µm to prepare a charge-transporting composition.

### [Comparative Example 1-2]

With 0.788 g of EG and 1.930 g of DEG were mixed 0.030 g of polythiophene derivative A and 0.048 g of 2-EHA, followed by stirring at 80°C for 1 hour using a hot stirrer. To the resulting mixture were added 0.965 g of 2-BOE and 4.826 g of TEGDME, followed by stirring. To this were added 0.300 g of a 10% by weight solution of aryl sulfonic acid B in ethylene glycol, 1.098 g of EG-ST and 0.015 g of phenyltrimethoxysilane (LS-2750, manufactured by Shin-Etsu Chemical Co., Ltd.), followed by stirring. The resulting mixture was filtered through a PP syringe filter having a pore size of 0.2 µm to prepare a charge-transporting composition.

### [Comparative Example 1-3]

With 0.941 g of EG and 1.930 g of DEG were mixed 0.030 g of polythiophene derivative A and 0.048 g of 2-EHA, followed by stirring at 80°C for 1 hour using a hot stirrer. To the resulting mixture were added 0.965 g of 2-BOE and 4.826 g of TEGDME To this were added 1.244 g of EG-ST and 0.015 g of phenyltrimethoxysilane (LS-2750, manufactured by Shin-Etsu Chemical Co., Ltd.), followed by stirring. The resulting mixture was filtered through a PP syringe filter having a pore size of 0.2 µm to prepare a charge-transporting composition.

### [3] Preparation and characterization of device

In the following Examples and Comparative Examples, as an ITO substrate, a 25 mm × 25 mm × 0.7 t glass substrate having ITO patterned on the surface with a film thickness of 150 nm was used. Before use, an O₂ plasma cleaning apparatus was used (150 W, for 30 seconds) to remove impurities on the surface.

### [3-1] Preparation and characterization of single-layer device (SLD)

### [Example 2-1]

The composition obtained in Example 1-1 was applied to the ITO substrate using a spin coater, then preliminarily baked at 120°C for 1 minute in the air, and subsequently mainly baked at 200°C for 15 minutes to form a 50 nm thin film on the ITO substrate.

On the thin film was formed an aluminum thin film using a vapor deposition apparatus (vacuum degree of 4.0 × 10⁻⁵ Pa) to prepare a single-layer device. The vapor deposition was performed under the condition of a vapor deposition rate of 0.2 nm/sec. The film thickness of the aluminum thin film was 80 nm.

In order to prevent deterioration of characteristics due to the influence of oxygen, water, etc. in the air, the SLD was sealed with sealing substrates and then its characteristics were evaluated. The sealing was performed by the following procedure.

In a nitrogen atmosphere with an oxygen concentration of 2 ppm or less and a dew point of -85°C or less, the SLD was placed between the sealing substrates, and the sealing substrates were bonded to each other with an adhesive (Moresco Moisture Cut WB90US (P), manufactured by MORESCO Corporation). At this time, a water catching agent (HD-071010W-40 manufactured by DYNIC Corporation) was contained in the sealing substrates together with the SLD. The bonded sealing substrates were irradiated with UV light (wavelength of 365 nm, irradiation dose of 6,000 mJ/cm²) and then annealed at 80°C for 1 hour to cure the adhesive.

### [Example 2-2]

An SLD was produced in the same manner as in Example 2-1 except that the composition obtained in Example 1-2 was used instead of the composition obtained in Example 1-1.

### [Example 2-3]

An SLD was produced in the same manner as in Example 2-1 except that the composition obtained in Example 1-3 was used instead of the composition obtained in Example 1-1.

For each SLD produced in the Examples, the current density at a drive voltage of 3 V was measured. The results are shown in Table 1.

**[Table 1]**

| | Charge-transporting composition | Current density (mA/cm²) |
|---|---|---|
| Example 2-1 | Example 1-1 | 1,160 |
| Example 2-2 | Example 1-2 | 1,690 |
| Example 2-3 | Example 1-3 | 1,450 |

### [3-2] Preparation and characterization of organic EL device

### [Example 3-1]

The composition obtained in Example 1-1 was applied to the ITO substrate using a spin coater, and then dried at 120°C for 1 minute in the air, followed by further baking at 200°C for 15 minutes to form a 50 nm uniform thin film (hole injection layer) on the ITO substrate.

On the thin film was deposited 30 nm of α-NPD (N,N'-di(1-naphthyl)-N,N'-diphenylbenzidine) using a vapor deposition apparatus (vacuum degree of 2.0×10⁻⁵ Pa). The vapor deposition rate at this time was 0.2 nm/sec. Next, a 10 nm film of the electronic block material HTEB-01 manufactured by Kanto Chemical Co., Inc. was deposited. Next, the light emitting layer host material NS60 manufactured by Nippon Steel & Sumikin Chemical Co., Ltd. and the light emitting layer dopant material Ir(PPy)₃ were co-deposited. For co-deposition, the vapor deposition rate was controlled such that the concentration of Ir(PPy)₃ was 6%, and 40 nm lamination was performed. Next, thin films of Alq₃, lithium fluoride and aluminum were sequentially laminated to prepare an organic EL device. At this time, the vapor deposition rate was 0.2 nm/sec for Alq₃ and aluminum, and 0.02 nm/sec for lithium fluoride. The film thicknesses of the thin films of Alq₃, lithium fluoride and aluminum were 20 nm, 0.5 nm and 80 nm, respectively.

In order to prevent deterioration of characteristics due to the influence of oxygen, water, etc. in the air, the organic EL device was sealed with sealing substrates and then its characteristics were evaluated. The sealing was performed in the same manner as described above.

### [Examples 3-2 to 3-3 and Comparative Examples 3-1 to 3-3]

Organic EL devices were produced in the same manner as in Example 3-1 except that the compositions obtained in Example 1-2 to 1-3 and Comparative Examples 1-1 to 1-3 were used instead of the composition obtained in Example 1-1.

For these devices, light emission images at a drive voltage of 4.5 V were observed. The results are shown in FIG. 1. In addition, the voltage, current efficiency, external light emitting quantum yield (EQE) and luminance lifetime (initial luminance of 5,000 cd/m²) at a luminance of 5,000 cd/m² were measured. The results are shown in Table 2. The area of the light emitting surface size of each device was set to 2 mm × 2 mm.

**[Table 2]**

| | Charge-transporting composition | Voltage (V) | Current efficiency (cd/A) | EQE (%) | Luminance lifetime (h) | |
|---|---|---|---|---|---|---|
| | | | | | LT95 | LT90 |
| Example 3-1 | Example 1-1 | 5.9 | 55.5 | 15.9 | 50 | 144 |
| Example 3-2 | Example 1-2 | 5.2 | 57.2 | 16.4 | 50 | 145 |
| Example 3-3 | Example 1-3 | 5.7 | 56.0 | 15.9 | - | - |
| Comparative Example 3-1 | Comparative Example 1-1 | 6.2 | 43.9 | 12.6 | 5 | 9 |
| Comparative Example 3-2 | Comparative Example 1-2 | 5.2 | 58.0 | 16.6 | 20 | 50 |
| Comparative Example 3-3 | Comparative Example 1-3 | 6.9 | 37.0 | 10.5 | - | - |

As apparent from FIG. 1, in many cases where the compositions of the Comparative Examples were used, unevenness on the surface of the obtained thin film was observed, and a thin film having high flatness could not be obtained. On the other hand, when the composition of the present invention was used, no surface unevenness was observed, and a charge-transporting thin film having excellent flatness could be produced with good reproducibility. Furthermore, as shown in Table 2, the organic EL device including the thin film obtained from the composition of the present invention (Example 3-1) has low drive voltage, high current efficiency and EQE, and extremely long luminance lifetime, as compared with the organic EL device including the thin film obtained from the composition of Comparative Example (Comparative Example 3-1). In addition, as compared with Comparative Example 3-2, Example 3-2 exhibited the same drive voltage, current efficiency and EQE, and had an extremely long luminance lifetime. In addition, as compared with Comparative Example 3-3, Example 3-3 had lower drive voltage, and higher current efficiency and EQE.

## Claims

1. A charge-transporting composition, comprising: a charge-transporting substance containing a polythiophene derivative including a repeating unit having a formula (1) or an amine adduct thereof; at least one organosilane compound selected from fluoroalkyl group-containing silanes and fluoroaryl group-containing silanes; metal oxide nanoparticles; and a solvent: 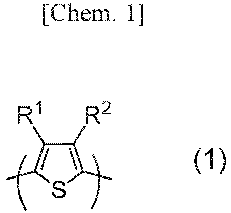 wherein R¹ and R² are each independently a hydrogen atom, a C1-40 alkyl group, a C1-40 fluoroalkyl group, a C1-40 alkoxy group, a C1-40 fluoroalkoxy group, a C6-20 aryloxy group, -O-[Z-O]ₚ-R^{e} or a sulfonic acid group, or are -O-Y-O- formed by a bonding of R¹ and R², wherein Y is a C1-40 alkylene group which may contain an ether bond or may be substituted with a sulfonic acid group, Z is a C1-40 alkylene group which may be substituted with a halogen atom, p is an integer of 1 or greater, R^{e} is a hydrogen atom, a C1-40 alkyl group, a C1-40 fluoroalkyl group or a C6-20 aryl group.

2. The charge-transporting composition according to claim 1, wherein the fluoroalkyl group-containing silanes and the fluoroaryl group-containing silanes have a fluoroalkyl group and a fluoroaryl group at a terminal of at least one molecule, respectively.

3. The charge-transporting composition according to claim 1 or 2, wherein the fluoroalkyl group and the fluoroaryl group are a perfluoroalkyl group and a perfluoroaryl group, respectively.

4. The charge-transporting composition according to claim 3, wherein the organosilane compound is at least one selected from following formulas (A1) and (B1): 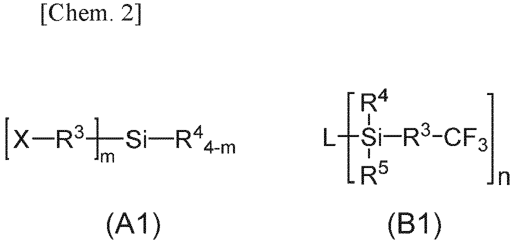 wherein R³ is a single bond, a C1-20 alkylene group, a C6-20 arylene group, an ester bond, an ether bond or a carbonyl bond, R⁴ and R⁵ are each independently a C1-20 alkyl group, a C1-20 alkoxy group or a C1-10 trialkylsilyl group, X is a C1-20 perfluoroalkyl group or a C6-20 perfluoroaryl group, L is O, S or N, m is 1 or 2, and n is 2 or 3.

5. The charge-transporting composition according to any one of claims 1 to 4, wherein the metal oxide nanoparticles are SiO₂.

6. The charge-transporting composition according to any one of claims 1 to 5, wherein R¹ is a sulfonic acid group and R² is a C1-40 alkoxy group or -O-[Z-O]ₚ-R^{e}, or R¹ and R² are -O-Y-O- formed by a bonding of R¹ and R².

7. The charge-transporting composition according to any one of claims 1 to 6, further comprising an electron-accepting dopant substance.

8. The charge-transporting composition according to claim 7, wherein the electron-accepting dopant substance is an aryl sulfonic acid compound.

9. A charge-transporting thin film obtained from the charge-transporting composition according to any one of claims 1 to 8.

10. An organic electroluminescence device having the charge-transporting thin film according to claim 9.

11. The organic electroluminescence device according to claim 9, wherein the charge-transporting thin film is a hole injection layer or a hole transport layer.

12. A method for producing a charge-transporting thin film, the method comprising applying the charge-transporting composition according to any one of claims 1 to 8 onto a substrate and evaporating a solvent.

13. A method for producing an organic electroluminescence device, the method comprising using the charge-transporting thin film according to claim 9.
